(19) Europäisches Patentamt
European Patent Office
Office européen des brevets

(11) **EP 3 032 581 B1**

(12) **EUROPÄISCHE PATENTSCHRIFT**

(45) Veröffentlichungstag und Bekanntmachung des Hinweises auf die Patenterteilung:
**09.10.2019 Patentblatt 2019/41**

(51) Int Cl.:
***H01L 25/07*** *(2006.01)*   ***H01L 23/373*** *(2006.01)*
***H02M 7/00*** *(2006.01)*

(21) Anmeldenummer: **14004182.3**

(22) Anmeldetag: **11.12.2014**

(54) **Schaltzellenanordnung für Wechselrichter**

Switching cell assembly for inverter

Agencement de cellule de commutation pour onduleur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.06.2016 Patentblatt 2016/24**

(73) Patentinhaber:
• **Dr. Johannes Heidenhain GmbH**
**83301 Traunreut (DE)**
• **Hochschule Rosenheim**
**83024 Rosenheim (DE)**

(72) Erfinder:
• **Seliger, Norbert**
**85604 Zorneding (DE)**
• **Stubenrauch, Franz**
**85543 Rott am Inn (DE)**

(74) Vertreter: **Flach Bauer Stahl**
**Patentanwälte Partnerschaft mbB**
**Adlzreiterstraße 11**
**83022 Rosenheim (DE)**

(56) Entgegenhaltungen:
| | |
|---|---|
| **EP-A1- 2 190 015** | **US-A1- 2002 024 135** |
| **US-A1- 2007 259 514** | **US-A1- 2008 197 463** |
| **US-A1- 2009 086 427** | **US-A1- 2012 243 192** |
| **US-A1- 2013 056 755** | **US-A1- 2013 207 121** |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Schaltzellenanordnung, die sich für den Aufbau hocheffizienter und hochtaktender Wechselrichter eignet. Außerdem beschreibt die Erfindung einen Umrichter, der aus zwei Schaltzellenanordnungen besteht und als AC/DC-DC/AC-Wandler arbeitet, wobei er einen Energiefluss in beide Richtungen erlaubt.

Immer höhere Ströme und steigende Taktraten stellen neue Herausforderungen an die moderne Leistungselektronik. Im Fokus steht dabei die Reduzierung der Schaltverluste und die effiziente Abfuhr der entstanden Verlustwärme.

Aus der US 2013/0056755 A1 ist ein dreiphasiger Wechselrichter bekannt, der drei Halbbrückenschaltungen umfasst, auf denen IGBTs zum Schalten von elektrischen Strömen angeordnet sind. Jede dieser Halbbrückenschaltungen umfasst neben zwei IGBTs noch zwei Dioden, die auf einem gemeinsamen Schaltungsträger angeordnet sind. Die IGBTs sind, wie auch die Dioden, auf unterschiedlichen Seiten des Schaltungsträgers angeordnet. Jeweils ein IGBT und eine Diode sind elektrisch über Bonddrähte miteinander verbunden. Die beiden IGBTs einer Halbbrückenschaltung sind weiterhin über Bonddrähte mit einer gemeinsamen Anschlussfläche verbunden.

Aus der DE 10 2013 108 148 A1 ist eine Halbbrückenschaltung bekannt, bei der die beiden notwendigen Halbschalterschaltelemente möglichst platzsparend angeordnet werden. Die Halbleiterschaltelemente sind dabei übereinander angeordnet, wobei nur ein Halbleiterschaltelement auf einem Bauteilträger angeordnet ist. Mittels Bonddrähten werden die Verbindungen zu den entsprechenden Anschlusskontakten geschaffen.

Nachteilig an der DE 10 2013 108 148 A1 ist, dass keine niederinduktive Anbindung an den Zwischenkreis und auch keine geringe Kapazität zwischen dem Phasenausgang und den Zwischenkreispotentialen realisiert werden kann. Die Kühlung der Halbbrückenschaltung ist ebenfalls nicht optimal, weil das Trennelement zwischen den beiden Halbleiterschaltelementen sehr dünn ausgeführt ist, wodurch nur eine unzureichende Wärmeabfuhr ermöglicht wird.

Es ist daher die Aufgabe der Erfindung eine effiziente Schaltzellenanordnung, vorzugsweise in Form einer Halbbrückenschaltung zu schaffen, die eine niederinduktive Anbindung an den Zwischenkreis erlaubt und zudem nur eine geringe Kapazität zwischen dem Phasenausgang und den Zwischenkreispotentialen aufweist. Gleichzeitig soll eine gute Wärmeabfuhr gewährleistet sein. Außerdem soll sich die Schaltzellenanordnung auch zum Aufbau eines Umrichters eignen.

Die Aufgabe wird bezüglich der Schaltzellenanordnung durch den unabhängigen Anspruch 1 und bezüglich des Umrichters durch den Anspruch 19 gelöst. Vorteilhafte Ausgestaltungen sind in den Unteransprüchen angegeben.

Die erfindungsgemäße Schaltzellenanordnung weist zumindest eine Schaltzelle auf. Diese Schaltzelle umfasst einen Schaltungsträger, zumindest zwei Halbleiterschaltelemente, wobei ein erstes Halbleiterschaltelement bevorzugt unmittelbar und/oder ausschließlich auf einer ersten Seite des Schaltungsträgers angeordnet und mit diesem elektrisch leitend verbunden, also beispielsweise verlötet ist und wobei ein zweites Halbleiterschaltelement bevorzugt unmittelbar und/oder ausschließlich auf einer zweiten, der ersten Seite gegenüberliegenden Seite des Schaltungsträgers angeordnet und mit diesem elektrisch leitend verbunden, also beispielsweise verlötet ist. Weiterhin ist ein erster Anschlussbereich des ersten Halbleiterschaltelements über eine erste elektrische Leitung, die in einem ersten Teil des Schaltungsträgers verläuft mit einem ersten Anschluss einer Gleichspannungsversorgung verbunden. Ein zweiter Anschlussbereich des zweiten Halbleiterschaltelements ist über eine zweite elektrische Leitung, die ebenfalls in dem ersten Teil des Schaltungsträgers verläuft mit einem zweiten Anschluss der Gleichspannungsversorgung verbunden. Ein zweiter Anschlussbereich des ersten Halbleiterschaltelements und ein erster Anschlussbereich des zweiten Halbleiterschaltelements sind miteinander und mit einem elektrisch leitfähigen zweiten Teil des Schaltungsträgers verbunden. Die erste elektrische Leitung und die zweite elektrische Leitung sind über zumindest eine Zwischenkreiskapazität miteinander verbunden, die auf dem Schaltungsträger angeordnet ist. Bei den Halbleiterschaltelementen handelt es sich um laterale Transistoren, bei denen alle Anschlussbereiche einzig auf einer Seite des Halbleiterschaltelements platziert sind.

Vorteilhaft ist, dass beide Halbleiterschaltelemente auf verschiedenen Seiten des Schaltungsträgers angebracht sind. Dadurch hängt die durch die erste und zweite elektrische Leitung aufgespannte Fläche hin zur Gleichspannungsversorgung maßgeblich nur von der Dicke des Schaltungsträgers ab. Diese Fläche kann viel kleiner ausgebildet werden, als wenn beide Halbleiterschaltelemente nebeneinander angeordnet werden würden. Dadurch wird eine niederinduktive Anbindung an den Zwischenkreis ermöglicht. Dadurch besteht die Möglichkeit die Halbleiterschaltelemente schneller zu schalten, wodurch die Schaltverluste reduziert werden. Es entsteht daher insbesondere für hohe Schaltfrequenzen weniger Verlustwärme. Außerdem ist es vorteilhaft, dass der zweite Teil des Schaltungsträgers leitfähig ist und dass der zweite Anschlussbereich des ersten Halbleiterschaltelements und der erste Anschlussbereich des zweiten Halbleiterschaltelements miteinander und mit dem elektrisch leitfähigen zweiten Teil des Schaltungsträgers verbunden sind, weil dadurch der elektrisch leitfähige zweite Teil des Schaltungsträgers als Wärmesenke dient und die durch die Schaltverluste anfallende Wärme effizient abgeführt werden kann. Eine solche symmetrische Anordnung lässt sich außerdem auch sehr einfach skalieren, sodass die als Halbbrückenschaltung arbeitende Schaltzellenanordnung sehr einfach zu einer Vollbrückenschaltung für eine oder mehrere Phasen erweiterbar und diese schließlich auch sehr einfach zu einem Umrichter aufrüstbar sind. Auch eine Parallelschaltung von mehreren der erfindungsgemäßen Schaltzellenanordnungen ist durch den symmetrischen Aufbau um den gemeinsamen Schaltungsträger herum sehr einfach möglich.

Außerdem besteht bei der erfindungsgemäßen Schaltzellenanordnung ein Vorteil, wenn ein erster oder ein zweiter Anschlussbereich des ersten oder des zweiten Halbleiterschaltelements aus einer elektrisch leitfähigen Anschlusskontaktfläche besteht, die sich über den gesamten jeweiligen Anschlussbereich erstreckt oder wenn ein erster oder ein zweiter Anschlussbereich des ersten oder zweiten Halbleiterschaltelements mehrere voneinander getrennte Anschlusskontakte aufweist, die dasselbe Potential haben. Ein mittels einer Anschlusskontaktfläche flächig ausgeführter Anschlussbereich kann sehr effizient zur gleichzeitigen Wärmeabfuhr verwendet werden. Voneinander getrennte Anschlusskontakte, die als sogenannte Anschlusskontaktinseln aufgebaut sind, können dabei sehr einfach hergestellt werden, wobei die Wärme über den flächigen Anschlussbereich abführbar ist. Bevorzugt weist jedes Halbleiterschaltelement zumindest einen flächig ausgeführten Anschlussbereich zur Wärmeabfuhr auf. Die Schaltzellenanordnung arbeitet bevorzugt als Halbbrücke, sodass bei dem High-Side-Halbleiterschaltelement der Source-Anschluss flächig ausgeführt ist, wohingegen bei den Low-Side-Halbleiterschaltelement bevorzugt der Drain-Anschluss flächig ausgeführt ist, sodass die Wärmeabfuhr über den gemeinsam genutzten leitfähigen zweiten Teil des Schaltungsträgers erfolgt. Es kann auch der Drain-Anschluss des High-Side-Halbleiterschaltelements flächig ausgeführt werden. In diesem Fall müsste allerdings der erste Teil des Schaltungsträgers zur Wärmeabfuhr für dieses Halbleiterschaltelement genutzt werden, was zwar möglich aber weniger effizient wäre. Es könnte auch jeweils der Source-Anschluss flächig ausgeführt sein.

Weiterhin besteht bei der erfindungsgemäßen Schaltzellenanordnung ein Vorteil, wenn der zweite Teil des Schaltungsträgers mindestens 90% der Breite des zweiten Anschlussbereichs des ersten Halbleiterschaltelements oder des ersten Anschlussbereichs des zweiten Halbleiterschaltelements aufweist oder wenn die erste elektrische Leitung und/oder die zweite elektrische Leitung mindestens 90% der Breite des ersten Anschlussbereichs des ersten Halbleiterschaltelements oder des zweiten Anschlussbereichs des zweiten Halbleiterschaltelements besitzt. Eine solche Breite erlaubt eine effiziente Wärmeabfuhr. Auch bei einer Breite von mehr als 60% oder mehr als 80% der Breite des zweiten Anschlussbereichs des ersten Halbleiterschaltelements oder des ersten Anschlussbereichs des zweiten Halbleiterschaltelements kann die Wärme noch effizient abgeführt werden. Außerdem kann dadurch ein niederinduktiver Aufbau erfolgen.

Zudem ist es vorteilhaft, wenn eine Anschlusskontaktfläche eine Größe von mehr als 30%, bevorzugt mehr als 40%, weiter bevorzugt mehr als 50%, weiter bevorzugt mehr als 60% aber weniger als 90% oder weniger als 80% der Grundfläche des ersten oder zweiten Halbleiterschaltelements aufweist. In diesem Fall kann über die Anschlusskontaktfläche sehr effizient die Verlustwärme abgeführt werden.

Ferner besteht bei der erfindungsgemäßen Schaltzellenanordnung ein Vorteil, wenn bei einer Draufsicht auf die erste Seite des Schaltungsträgers die erste elektrische Leitung über einen Bereich von mehr als 50% der Länge, bevorzugt mehr als 60% der Länge, weiter bevorzugt mehr als 70% der Länge, weiter bevorzugt mehr als 80% der Länge, weiter bevorzugt mehr als 90% der Länge deckungsgleich zur zweiten elektrischen Leitung verläuft. Dabei sind beide elektrischen Leitungen galvanisch voneinander getrennt auf verschiedenen Lagen des ersten Teils des Schaltungsträgers angeordnet. Dies erlaubt eine besonders niederinduktive Anbindung an die Gleichspannungsversorgung. Bei der Gleichspannungsversorgung handelt es sich bevorzugt um einen Zwischenkreis, insbesondere um zumindest einen Kondensator, über den die beiden elektrischen Leitungen miteinander verbunden sind. Dieser Zwischenkreis wird von einer Gleichspannungsquelle gespeist. Hochfrequenzsignale, die beim Schalten entstehen werden durch die Zwischenkreiskapazität kurzgeschlossen und breiten sich nicht auf der Energieversorgungsleitung aus.

Außerdem besteht bei der erfindungsgemäßen Schaltzellenanordnung ein Vorteil, wenn die erste elektrische Leitung überwiegend auf der ersten Seite des ersten Teils des Schaltungsträgers verläuft und wenn die zweite elektrische Leitung überwiegend auf der zweiten Seite des ersten Teils des Schaltungsträgers verläuft. Dies heißt mit anderen Worten, dass der größte Teil der Länge, also mehr als 50% der Länge, bevorzugt mehr 70% der Länge, weiter bevorzugt mehr als 80% der Länge, weiter bevorzugt mehr als 90% der Länge der jeweiligen elektrischen Leitung auf der jeweiligen Seite des Schaltungsträgers verlaufen soll oder kann. Dadurch ist sichergestellt, dass die elektrischen Leitungen deckungsgleich angeordnet werden können, weil sie bezüglich ihrer Länge überwiegend auf verschiedenen Seiten des Schaltungsträgers angeordnet sind. Dadurch wird ein niederinduktiver Aufbau für die Schaltzelle erreicht. Für den Fall, dass es sich bei dem Schaltungsträger um einen mehrlagigen Schaltungsträger handelt, ist der Begriff Seite auch als Lage zu verstehen, wobei die elektrischen Leitungen jeweils bevorzugt auf den am wenigsten zueinander beabstandeten Lagen angeordnet sind. Der minimale Abstand zueinander wird dabei durch die Isolationsfestigkeit des Dielektrikums des Schaltungsträgers bestimmt.

Zusätzlich besteht bei der erfindungsgemäßen Schaltzellenanordnung ein Vorteil, wenn bei einer Draufsicht auf die erste Seite des Schaltungsträgers das erste Halbleiterschaltelement und das zweite Halbleiterschaltelement deckungsgleich angeordnet sind oder wenn sich bei einer Draufsicht auf die erste Seite des Schaltungsträgers das erste Halbleiterschaltelement und das zweite Halbleiterschaltelement zu mehr als 20%, bevorzugt zu mehr als 30%, weiter bevorzugt zu mehr als 40%, weiter bevorzugt zu mehr als 50%, weiter bevorzugt zu mehr als 60%, weiter bevorzugt zu mehr als 70%, weiter bevorzugt zu mehr als 80%, weiter bevorzugt zu mehr als 90% aber zu weniger als 95%. Gegebenenfalls kann bei einer Draufsicht auf die erste Seite des Schaltungsträgers das erste Halbleiterschaltelement und das zweite Halbleiterschaltelement sogar vollständig versetzt zueinander angeordnet sein. Der Wortlaut "Draufsicht" ist dabei derart zu verstehen, als ob der Schaltungsträger ausgeblendet oder durchsichtig ist. Ein Vorteil bei einer vollständigen Überlappung der Halbleiterschaltelemente ist, dass die Schaltzellenanordnung symmetrisch aufgebaut werden kann, wodurch eine äußerst niederinduktive Anbindung an die Gleichspannungsversorgung möglich ist. Der Wortlaut "deckungsgleich" ist dabei bevorzugt so zu verstehen, dass die Halbleiterschaltelemente in einem gedachten X-/Y-Koordinatensystem die gleichen Abmessungen und die gleiche Lage haben und sich nur bezüglich ihrer Lage in der Z-Achse voneinander unterscheiden. Für den Fall, dass sich die Halbleiterschaltelemente nicht vollständig überlappen, kann zusätzlich in Querrichtung, also senkrecht zum Schaltungsträger, die Wärme über einen Kühlkörper abgeführt werden. Eine erhöhte Wärmespreizung ist dadurch möglich.

Zudem besteht bei der erfindungsgemäßen Schaltzellenanordnung ein Vorteil, wenn der erste Teil und der zweite Teil des Schaltungsträgers bevorzugt die gleiche Längsachse haben und einen Winkel von 180° zueinander bilden, sich also beispielsweise diametral gegenüberstehen. Dies bedeutet, dass die erste und/oder zweite elektrische Leitung zu dem zweiten Teil einen Winkel von 180° bilden, also die Ströme auf der ersten und/oder zweiten elektrischen Leitung und dem zweiten Teil in die gleiche oder die entgegengesetzte Richtung fließen. Dadurch kann die Schaltzellenanordnung besonders symmetrisch aufgebaut werden, wobei die Grenze zwischen beiden Teilen bevorzugt unterhalb der Halbleiterschaltelemente verläuft.

Zudem besteht bei der erfindungsgemäßen Schaltzellenanordnung ein weiterer Vorteil insoweit als die erste elektrische Leitung und die zweite elektrische Leitung mittels Dickkupfertechnologie gebildet sein kann und/oder der zweite Teil des Schaltungsträgers elektrisch leitfähige Oberflächen aufweisen kann, die mittels Dickkupfertechnologie gebildet sind, wobei diese Oberflächen mittels einer Vielzahl von Durchkontaktierungen galvanisch miteinander verbunden sein können. Alternativ oder ergänzend kann der zweite Teil des Schaltungsträgers ein elektrisch leitfähiges Inlay aufweisen, das bevorzugt aus Kupfer gebildet ist. Der Einsatz der Dickkupfertechnologie erlaubt eine besonders hohe Wärmeabfuhr. Für den Fall, dass die Wärmeabfuhrkapazität noch gesteigert werden soll, kann der zweite Teil mit einer Vielzahl von Durchkontaktierungen versehen werden, sodass nicht nur der zweite Anschlussbereich des ersten Halbleiterschaltelements und der erste Anschlussbereich des zweiten Halbleiterschaltelements niederohmig, sowie niederinduktiv miteinander verbunden sind, sondern auch mehr Verlustwärme abgeführt werden kann. Mittels der Dickkupfertechnologie können Schichtdicken realisiert werden, die dicker sind als 100 $\mu$m, bevorzugt dicker sind als 200 $\mu$m, weiter bevorzugt dicker sind als 300 $\mu$m und weiter bevorzugt dicker sind als 400 $\mu$m und weiter bevorzugt dicker sind als 800 $\mu$m. Der zweite Teil weist in zumindest einem Teilbereich mehr als 5 Durchkontaktierungen pro cm$^2$ auf. Bevorzugt weist der zweite Teil in zumindest einem Teilbereich mehr als 10 Durchkontaktierungen pro cm$^2$ und weiter bevorzugt mehr als 15 Durchkontaktierungen pro cm$^2$ und weiter bevorzugt mehr als 20 Durchkontaktierungen pro cm$^2$ auf. Dadurch kann der aus mehreren Schichten bestehende zweite Teil, bei dem es sich um eine normale Leiterplatte handeln kann, sehr viel Verlustwärme abführen. Die Herstellung eines solchen Schaltungsträgers ist außerdem besonders einfach möglich. Für den Fall, dass die Wärmeabfuhrkapazität noch weiter gesteigert werden soll, kann ein Inlay in den zweiten Teil eingesetzt werden. Bevorzugt wird z.B. mittels eines Fräs- oder Stanzprozesses eine Ausnehmung innerhalb des zweiten Teils des Schaltungsträgers gebildet. In diese Ausnehmung kann ein elektrisch und thermisch leitfähiges Inlay, welches bevorzugt aus Kupfer gebildet ist, eingesetzt, bevorzugt eingepresst werden. Über eine optionale Fügeverbindung, beispielsweise in Form einer Klebeverbindung, ist ein fester Sitz dauerhaft gewährleistet. Der zweite Anschlussbereich des ersten Halbleiterschaltelements und/oder der erste Anschlussbereich des zweiten Halbleiterschaltelements können zumindest teilweise, insbesondere zu mehr als 50% ihrer Fläche, bevorzugt vollständig auf den beiden Seiten des Inlays ausgebildet sein.

Außerdem ist es bei der erfindungsgemäßen Schaltzellenanordnung vorteilhaft,

- wenn es sich bei dem ersten Anschlussbereich um einen Source-Anschluss und bei dem zweiten Anschlussbereich um einen Drain-Anschluss handelt und/oder

- wenn es sich bei dem Halbleiterschaltelement um einen lateralen Transistor beispielsweise auf SI-Basis oder auf GaN-Basis handelt und/oder

- wenn das Halbleiterschaltelement ungehäust elektrisch leitend mit dem Schaltungsträger verbunden ist. Das Halbleiterschaltelement kann dazu beispielsweise bevorzugt unter Umgehung von Bondverbindungen direkt auf den Schaltungsträger gelötet sein und/oder

- wenn das erste Halbleiterschaltelement und das zweite Halbleiterschaltelement bezüglich ihres ersten und zweiten Anschlussbereichs spiegelsymmetrisch aufgebaut sind und/oder

- wenn es sich bei der Gleichspannungsversorgung um eine Zwischenkreiskapazität handelt.

Erfindungsgemäß eignet sich ein lateraler Transistor aufgrund des internen Ladungsträgerflusses für den Aufbau der erfindungsgemäßen Schaltzellenanordnung, weil alle Anschlussbereiche ohne den Einsatz von Bondingdrähten aus dem Chip rausgeführt werden, wodurch die parasitären Induktivitäten weiter reduziert werden. Dies wäre durch den Einsatz von Transistoren mit vertikalem Stromfluss zwar möglich, allerdings müsste dann eine flächige Bondverbindung zur niederinduktiven Anbindung realisiert werden. Das ungehäuste elektrische Verbinden, beispielsweise durch Auflöten, erlaubt ebenfalls eine sehr effiziente Wärmeabfuhr, weil zusätzliche Wärmeübergangswiderstände durch das Gehäuse vermieden werden. Durch den spiegelsymmetrischen Aufbau beider Halbleiterschaltelemente ist sichergestellt, dass die flächig ausgeführten Anschlussbereiche stets im zweiten Teil des Schaltungsträgers liegen, sodass nur dieser Teil bezüglich seiner Wärmeabfuhrkapazität angepasst werden muss.

Zusätzlich hat es sich im Rahmen der Erfindung als günstig erwiesen, wenn die Schaltzellenanordnung zumindest zwei Schaltzellen aufweist oder umfasst, wobei die zumindest zwei Schaltzellen parallel zueinander geschaltet sind und einen Schaltzellenparallelblock bilden und auf einem gemeinsamen Schaltungsträger ausgebildet sind. Bevorzugt sind daher die jeweils ersten elektrischen Leitungen und die jeweils zweiten elektrischen Leitungen der zumindest zwei Schaltzellen galvanisch miteinander verbunden. Ferner sind die zumindest beiden elektrisch leitfähigen zweiten Teile bevorzugt galvanisch miteinander verbunden. Dies erlaubt die Übertragung von höheren Strömen, wobei sichergestellt sein soll, dass die jeweiligen Halbleiterschaltelemente auch gleichzeitig schalten. Dies wird dadurch erreicht, dass die Steuerleitung, bei der es sich bevorzugt um die Leitung zum Gate-Anschluss des jeweiligen Halbleiterschaltelements handelt, von jeder Schaltzelle genau gleich lang ist. Außerdem sind dabei bevorzugt die ersten elektrischen Leitungen und die zweiten elektrischen Leitungen nicht nur an einem Punkt miteinander verbunden, sondern über mehr als 50% ihrer Gesamtlänge, also zu über 50% einteilig ausgebildet. Gleiches gilt auch für die zweiten Teile jeder Schaltzelle. Diese sind ebenfalls bevorzugt einteilig ausgebildet und nicht nur in einem Punkt miteinander galvanisch verbunden.

Außerdem besteht bei der erfindungsgemäßen Schaltzellenanordnung ein Vorteil, wenn zwei Schaltzellen oder zwei Schaltzellenparallelblöcke vorgesehen sind und wenn dabei die

- jeweils ersten elektrischen Leitungen jeder Schaltzelle oder jedes Schaltzellenparallelblocks miteinander verbunden sind, und
- die jeweils zweiten elektrischen Leitungen jeder Schaltzelle oder jedes Schaltzellenparallelblocks miteinander verbunden sind, und

- der zweite Teil der ersten Schaltzelle oder des ersten Schaltzellenparallelblocks mit einem ersten Anschluss einer elektrischen Maschine verbindbar ist oder verbunden ist, und
- der zweite Teil der zweiten Schaltzelle oder des zweiten Schaltzellenparallelblocks mit einem zweiten Anschluss der elektrischen Maschine verbindbar ist oder verbunden ist.

In diesem Fall sind die zwei Schaltzellen oder die zwei Schaltzellenparallelblöcke als Vollbrücke betreibbar. Unter einer elektrischen Maschine ist jeder elektrische Verbraucher gemeint. Der Wortlaut soll allerdings auch ausdrücken, dass der Energiefluss einerseits in den Verbraucher hinein stattfindet und andererseits auch in Gegenrichtung aus dem Verbraucher heraus möglich sein soll, der Verbraucher sozusagen als Generator betrieben wird. Ein Mehrquadrantenbetrieb ist dadurch möglich. Insbesondere ein Anschluss an einen Transformator ist denkbar.

Zusätzlich besteht bei der erfindungsgemäßen Schaltzellenanordnung ein Vorteil, wenn die zwei Schaltzellen oder die zwei Schaltzellenparallelblöcke auf einem gemeinsamen Schaltungsträger ausgebildet sind oder wenn die zwei Schaltzellen oder die zwei Schaltzellenparallelblöcke mittels Abstandshalter übereinander angeordnet sind. Durch diesen symmetrischen Aufbau wird eine niederinduktive und kompakte Vollbrücke erschaffen.

Es hat sich ferner als günstig herausgestellt, wenn die erfindungsgemäße Schaltzellenanordnung n-Schaltzellen oder n-Schaltzellenparallelblöcke mit $n > 2$ und $n \in \mathbb{N}$ aufweist und wenn die jeweils ersten elektrischen Leitungen jeder der n-Schaltzellen oder jeder der n-Schaltzellenparallelblöcke miteinander galvanisch verbunden sind. Dabei sollten die jeweils zweiten elektrischen Leitungen jeder der n-Schaltzellen oder jeder der n-Schaltzellenparallelblöcke miteinander galvanisch verbunden sein. Zudem sollte der zweite Teil jeder der n-Schaltzellen oder jeder der n-Schaltzellenparallelblöcke mit einem der n-Anschlüsse einer elektrischen Maschine verbindbar oder verbunden sein. In diesem Fall ist die Schaltzellenanordnung als n-phasiger Wechselrichter, oder als n-phasiger Gleichstromsteller, oder als n-phasiger DC/DC-Wandler betreibbar.

Ebenso kann die erfindungsgemäße Schaltzellenanordnung n-Schaltzellen oder n-Schaltzellenparallelblöcke umfassen, auf einem gemeinsamen Schaltungsträger ausgebildet sind, wobei die Gleichspannungsversorgung den Schaltungsträger in zwei Bereiche teilt. Die **(2 ·(n-2))-**Schaltzelle oder der **(2·(n-2))-**Schaltzellenparallelblock können orthogonal zu der Gleichspannungsversorgungsleitung ausgebildet und mit dieser verbunden und voneinander beabstandet in dem ersten Bereich angeordnet sein, wobei die **((2·(n-2))-1)-**Schaltzelle oder der **((2·(n-2))-1)-**Schaltzellenparallelblock bevorzugt orthogonal zu der Gleichspannungsversorgungsleitung ausgebildet und mit dieser verbunden ist. Die erwähnte Schaltzelle oder der erwähnte Schaltzellenparallelblock sind voneinander beabstandet in dem zweiten Bereich angeordnet. Möglich ist auch die n-Schaltzellen oder die n-Schaltzellenparallelblöcke mittels Abstandshalter übereinander anzuordnen. Dies bedeutet, dass z.B. alle "geraden" Schaltzellen oder Schaltzellenparallelblöcke in einem ersten Bereich angeordnet und mit der Gleichspannungsversorgungsleitung verbunden sind, wohingegen alle "ungeraden" Schaltzellen oder Schaltzellenparallelblöcke in dem zweiten Bereich angeordnet und mit der Gleichspannungsversorgungsleitung verbunden sind. Dabei ist bevorzugt ein Pol der Gleichspannungsversorgungsleitung auf einer Seite des Schaltungsträgers ausgebildet und der zweite Pol der Gleichspannungsversorgungsleitung auf der zweiten Seite des Schaltungsträgers.

Ferner besteht bei der erfindungsgemäßen Schaltzellenanordnung ein Vorteil, wenn die n-Schaltzellen oder die n-Schaltzellenparallelblöcke zu ihrer benachbarten n-Schaltzelle oder zu seinem benachbarten n-Schaltzellenparallelblock einen Winkel von

$$\gamma = \frac{360°}{n}$$ bildet, wobei die ersten und zweiten elektrischen Leitungen jeder der n-Schaltzellen oder der n-Schaltzellenparallelblöcke näher an einem gemeinsamen Zentrum in der Mitte der Schaltzellenanordnung liegen, als der zweite Anschlussbereich des ersten Halbleiterschaltelements oder der erste Anschlussbereich des zweiten Halbleiterschaltelements jeder der n-Schaltzellen oder der n-Schaltzellenparallelblöcke.

Ebenso ist es in vorteilhafter Weise möglich den ersten Anschluss der Gleichspannungsversorgung im Zentrum auf der ersten Seite des Schaltungsträgers und den zweiten Anschluss der Gleichspannungsversorgung im Zentrum auf der zweiten Seite des Schaltungsträgers anzuordnen. Die n-Schaltzellen oder die n-Schaltzellenparallelblöcke können dabei derart auf dem Schaltungsträger positioniert werden, dass sie sich vom Zentrum radial nach außen erstrecken, wobei jede der n-Schaltzellen oder jeder der n-Schaltzellenparallelblöcke zu ihrer benachbarten n-Schaltzelle oder zu seinem benachbarten n-Schaltzellenparallelblock einen Winkel von

$$\gamma = \frac{360°}{n}$$  bildet.

Vorteilhaft ist ebenso, den zweiten Anschluss der Gleichspannungsversorgung im Zentrum des Schaltungsträgers anzuordnen oder auszubilden, wobei der erste Anschluss als umlaufende ringförmige Fläche ausgeführt sein kann. In der Mitte des umlaufend ringförmig ausgebildeten ersten Anschlusses kann galvanisch getrennt von diesem der zweite Anschluss der Gleichspannungsversorgung positioniert werden. Die n-Schaltzellen oder die n-Schaltzellenparallelblöcke können dann derart auf dem Schaltungsträger so angeordnet sein, dass sie sich vom Zentrum radial nach außen erstrecken, wobei jede der n-Schaltzellen oder jeder der n-Schaltzellenparallelblöcke zu ihrer benachbarten n-Schaltzelle oder zu seinem benachbarten n-Schaltzellenparallelblock einen Winkel von $$\alpha = \frac{360°}{n}$$ bildet.

Der erfindungsgemäße Umrichter erweist sich schließlich als vorteilhaft,

- weil beide Schaltzellenanordnungen mittels Abstandshaltern übereinander angeordnet sind, und/oder
- weil eine erste Schaltzellenanordnung eine Wechselspannung gleichrichten kann,
- weil eine zweite Schaltzellenanordnung eine von der ersten Schaltzellenanordnung bezogene Gleichspannung wechselrichten kann,
- weil die zweite Schaltzellenanordnung eine Wechselspannung gleichrichten kann,
- weil die erste Schaltzellenanordnung eine von der zweiten Schaltzellenanordnung bezogene Gleichspannung wechselrichten kann, sodass ein Energiefluss in beide Richtungen ermöglicht ist.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnung zeigen im Einzelnen:

Figur 1A:      ein Prinzipschaltbild der erfindungsgemäßen Schaltzelle;

Figur 1B-E:    die einzelnen Anschlussbereiche verschiedener Halbleiterschaltelemente, die in der erfindungsgemäßen Schaltzelle eingesetzt werden können;

Figur 2A-C:    eine teilweise geschnittene Seitenansicht durch die erfindungsgemäße Schaltzelle, die den Aufbau der Schaltzelle näher erläutert;

Figur 3A:      eine teilweise geschnittene Seitenansicht durch die erfindungsgemäße Schaltzelle, wobei die beiden Halbleiterschaltelemente nicht deckungsgleich zueinander angeordnet sind;

Figur 3B-E:    eine prinzipielle Anordnung der Halbleiterschaltelemente zueinander;

Figur 4A-B:    eine Draufsicht auf eine Seite der erfindungsgemäßen Schaltzelle;

Figur 5:       eine Draufsicht auf eine Seite eines Schaltzellenparallelblocks, der aus zwei parallel geschalteten erfindungsgemäßen Schaltzellen besteht;

Figur 6A:     ein Prinzipschaltbild einer Vollbrücke zur Versorgung einer elektrischen Maschine;

Figur 6B:     eine Draufsicht auf eine erste Seite der aus zwei erfindungsgemäßen Schaltzellen bestehenden Vollbrücke, wobei sich beide Schaltzellen den Schaltungsträger teilen;

Figur 7A:     ein Prinzipschaltbild eines aus drei erfindungsgemäßen Schaltzellen bestehenden dreiphasigen Umrichters;

Figur 7B-C:     eine Draufsicht auf einen aus drei erfindungsgemäßen Schaltzellen bestehenden dreiphasigen Umrichter; und

Figur 7D:     eine Draufsicht auf einen aus n erfindungsgemäßen Schaltzellen bestehenden n-phasigen Umrichter.

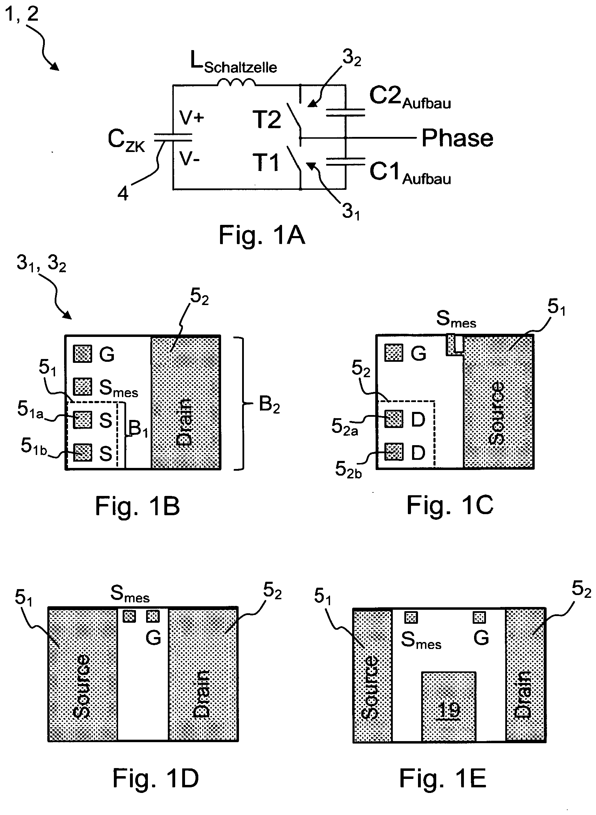

Figur 1A zeigt ein Prinzipschaltbild einer Schaltzellenanordnung 1 mit zumindest einer erfindungsgemäßen Schaltzelle 2. Die Schaltzelle 2 besitzt, wie aus den weiteren Figuren 1B bis 2C zu entnehmen ist, eine Halbbrückenstruktur. Sie besteht aus zumindest zwei Halbleiterschaltelementen $3_1$, $3_2$, die mit einer Gleichspannungsversorgung 4 verbunden sind. Ein erster Anschlussbereich $5_1$ des ersten Halbleiterschaltelementes $3_1$ ist über eine erste elektrische Leitung $6_1$ in einem ersten Teil $7_1$ des Schaltungsträgers 8 mit einem ersten Anschluss $4_1$ der Gleichspannungsversorgung 4 verbunden. Ein zweiter Anschlussbereich $5_2$ des zweiten Halbleiterschaltelementes $3_2$ ist über eine zweite elektrische Leitung $6_2$ in dem ersten Teil $7_1$ des Schaltungsträgers 8 mit einem zweiten Anschluss $4_2$ der Gleichspannungsversorgung 4 verbunden. Ein zweiter Anschlussbereich $5_2$ des ersten Halbleiterschaltelementes $3_1$ und ein erster Anschlussbereich $5_1$ des zweiten Halbleiterschaltelementes $3_2$ sind miteinander und mit einem elektrisch leitfähigen zweiten Teil $7_2$ des Schaltungsträgers 8 verbunden.

In Figur 1A ist ebenfalls die Schleifeninduktivität $L_{Schaltzelle}$ zu erkennen, die zwischen den Halbleiterschaltelementen $3_1$, $3_2$ und dem Zwischenkreiskondensator 4, also der Gleichspannungsversorgung 4 entsteht. Die Größe der Induktivität wird maßgeblich durch die vom Hin- und Rückleiter aufgespannte Fläche beeinflusst. Für ein ideales elektrisches Verhalten muss die Schleifeninduktivität so klein wie möglich gehalten werden. Dies kann durch eine flächige Ausführung des Hin- und Rückleiters mit geringem Leiterabstand erreicht werden. Theoretisch kann der Abstand so weit reduziert werden, bis die maximale mögliche Isolationsspannung des Isolatormaterials 20 erreicht wird.

Weiterhin kritisch sind die Kapazitäten $C1_{Aufbau}$ und $C2_{Aufbau}$. Diese müssen bei jedem Schaltvorgang der Halbleiterschaltelemente $3_1$, $3_2$ umgeladen werden und verursachen zusätzliche Schaltverluste. Wie nachfolgend noch erläutert wird, besteht der Vorteil der erfindungsgemäßen Schaltzelle 2 darin, dass die Kapazitäten baubedingt auf bevorzugt weniger als ein pF gehalten werden können und zusätzlich ein großflächiger, thermisch hoch leitfähiger Phasenanschluss realisiert werden kann.

Die Figuren 1B bis 1E zeigen die einzelnen Anschlussbereiche $5_1$, $5_2$ des ersten und/oder zweiten Halbleiterschaltelementes $3_1$, $3_2$. In dem Beispiel aus Figur 1B handelt es sich bei dem ersten Anschlussbereich $5_1$ um den Source-Anschluss des entsprechenden Halbleiterschaltelementes $3_1$, $3_2$. Bei dem zweiten Anschlussbereich $5_2$ handelt es sich um den Drain-Anschluss, der flächig ausgeführt ist. Dargestellt sind weiterhin ein Abgriff zur Steuerung des Gate-Anschlusses und zusätzlich ein Abgriff für die Steuerung am Source-Anschluss. Der Gate-Anschluss und der Steuer-Abgriff für die Source-Spannung werden einem nicht dargestellten Treiber zugeführt.

In dem Beispiel aus Figur 1C ist der erste Anschlussbereich $5_1$ in Form des Source-Anschlusses des entsprechenden Halbleiterschaltelementes $3_1$, $3_2$ flächig ausgeführt. Der zweite Anschlussbereich $5_2$ in Form des Drain-Anschlusses ist in Form von zumindest zwei Anschlusskontakten $5_{2a}$, $5_{2b}$ ausgeführt.

Figur 1D zeigt ein Ausführungsbeispiels eines Halbleiterschaltelementes $3_1$, $3_2$, bei welchem beide Anschlussbereiche $5_1$, $5_2$ flächig ausgeführt sind.

Zu erkennen ist, dass sich eine elektrisch leitfähige Anschlusskontaktfläche des ersten und zweiten Anschlussbereiches $5_1$, $5_2$ über den gesamten ersten und zweiten Anschlussbereich $5_1$, $5_2$ erstreckt. Innerhalb der Figuren 1B und 1C erstreckt sich die elektrische Anschlusskontaktfläche nur über eine Teil des ersten und/oder zweiten Anschlussbereiches $5_1$, $5_2$. Innerhalb von Figur 1B weist der erste Anschlussbereich $5_1$ mehrere voneinander getrennte Anschlusskontakte $5_{1a}$, $5_{1b}$ auf, die die Anschlusskontaktfläche bilden. Diese Anschlusskontakte $5_{1a}$, $5_{1b}$ haben alle dasselbe Potential, in diesem Fall das Potential des Source-Anschlusses. Man kann auch sagen, dass es sich bei diesen Anschlusskontakten $5_{1a}$, $5_{1b}$ um sogenannte Anschlusskontaktinseln handelt, die von anderen elektrisch leitfähigen Bereichen galvanisch getrennt sind. Diese sogenannten Anschlusskontakte $5_{1a}$, $5_{1b}$ weisen zusammen eine Fläche auf, die bevorzugt größer als 30%, weiter bevorzugt größer als 40%, weiter bevorzugt größer als 50%, weiter bevorzugt größer als 60%, allerdings kleiner als 80% der Fläche des zweiten Anschlussbereiches $5_2$ ist. Der erste Anschlussbereich $5_1$ ist dabei kleiner als der zweite, bevorzugt flächig ausgeführte Anschlussbereich $5_2$. Bevorzugt weist er eine Größe von weniger als 60% des zweiten Anschlussbereichs $5_2$ auf.

Gleiches gilt auch innerhalb von Figur 1C für

den zweiten Anschlussbereich $5_2$, der eine Anschlusskontaktfläche aufweist, die aus mehreren Anschlusskontakten $5_{2a}$, $5_{2b}$ besteht. Diese sogenannten Anschlusskontakte $5_{2a}$, $5_{2b}$ des zweiten Anschlussbereichs $5_2$ weisen zusammen eine Fläche auf, die bevorzugt größer als 30%, weiter bevorzugt größer als 40%, weiter bevorzugt größer als 50%, weiter bevorzugt größer als 60%, allerdings kleiner als 90% oder kleiner als 80% der Fläche des ersten Anschlussbereiches $5_1$ ist. Der zweite Anschlussbereich $5_2$ ist dabei kleiner als der erste, bevorzugt flächig ausgeführte Anschlussbereich $5_1$.

Für den Fall, das ein erster oder zweiter Anschlussbereich $5_1$, $5_2$ des ersten oder zweiten Halbleiterschaltelementes $3_1$, $3_2$ aus einer elektrisch leitfähigen Anschlusskontaktfläche $5_{1a}$, $5_{1b}$, $5_{2a}$, $5_{2b}$ besteht, die sich über den gesamten jeweiligen Anschlussbereich $5_1$, $5_2$ erstreckt, wie dies in Figur 1B für den zweiten Anschlussbereich $5_2$, in Figur 1C für den ersten Anschlussbereich $5_1$ und in Figur 1D für beide Anschlussbereiche $5_1$, $5_2$ zutrifft, wird von einem flächig ausgeführten Anschlussbereich $5_1$, $5_2$ geredet. Ein solcher flächig ausgeführter erster und/oder zweiter Anschlussbereich $5_1$, $5_2$ besitzt eine Anschlusskontaktfläche, die bevorzugt eine Größe von mehr als 30%, bevorzugt mehr als 40%, weiter bevorzugt mehr als 50%, weiter bevorzugt mehr als 60% und weniger als 90% oder weniger als 80% der Grundfläche des ersten und/oder zweiten Halbleiterschaltelementes $3_1$, $3_2$ aufweist.

Ein solcher flächig ausgeführter Anschlussbereich $5_1$, $5_2$ eignet sich hervorragend zur Abfuhr überschüssiger Verlustwärme, die unter anderem durch das Umladen der halbleiterinternen Kapazitäten, sowie der Kapazitäten $C1_{Aufbau}$ und $C2_{Aufbau}$ während der Schaltvorgänge entsteht.

Um sowohl den Drain- als auch den Source-Anschluss der Halbleiterschaltelemente $3_1$, $3_2$ niederinduktiv in die erfindungsgemäße Schaltzelle 2 zu integrieren, sind laterale Bauteile von Vorteil, weil deren Anschlüsse einzig auf einer Seite des Halbleiters platziert sind. Zu diesen Typen zählen beispielsweise Gallium-Nitrid-Halbleiter. Diese haben im Vergleich zu Silizium ein besseres Durchlassverhalten bei gleicher Chipgröße, bzw. bei gleichem Durchlassverhalten geringere parasitäre Kapazitäten. Bei den sogenannten lateralen Bauteilen müssen im Gegensatz zu Bauteilen mit vertikalem Stromfluss, keine Bonddrähte verwendet werden, um die einzelnen Schichten mit den Anschlusskontakten zu verbinden. Dadurch kann das Entstehen zusätzlicher Induktivitäten in der erfindungsgemäßen Schaltzelle 2 verhindert, bzw. reduziert werden.

Bei Halbleiterschaltelementen, die beispielsweise auf Gallium-Nitrid-Basis gebildet sind besteht daher die Möglichkeit, dass diese ungehäust direkt mit dem Schaltungsträger 8 elektrisch leitend verbunden werden können, wodurch außerdem die Gehäusekosten des Halbleiterschaltelementes $3_1$, $3_2$ entfallen und der Wärmeübergangswiderstand gesenkt wird.

Figur 1E zeigt ein Ausführungsbeispiel eines Halbleiterschaltelementes $3_1$, $3_2$, bei welchem beide Anschlussbereiche $5_1$, $5_2$ kleinflächig ausgeführt sind, was bedeutet, dass die Fläche jedes Anschlussbereichs weniger als 30%, bevorzugt weniger als 20% der Grundfläche des Halbleiterschaltelementes $3_1$, $3_2$ ausmacht, allerdings bevorzugt keine voneinander getrennten Kontaktinseln aufweist. Weiterhin ist ein Heat-Pad 19 dargestellt, welches eine kleinere Fläche oder eine gleich große Fläche oder eine größere Fläche aufweist, als der erste oder zweite Anschlussbereich $5_1$, $5_2$. Das Heat-Pad 19 kann auf das Potential des ersten oder zweiten Anschlussbereichs $5_1$, $5_2$ gelegt werden, sodass sich dessen zur Kühlung wirksame Fläche entsprechend vergrößert.

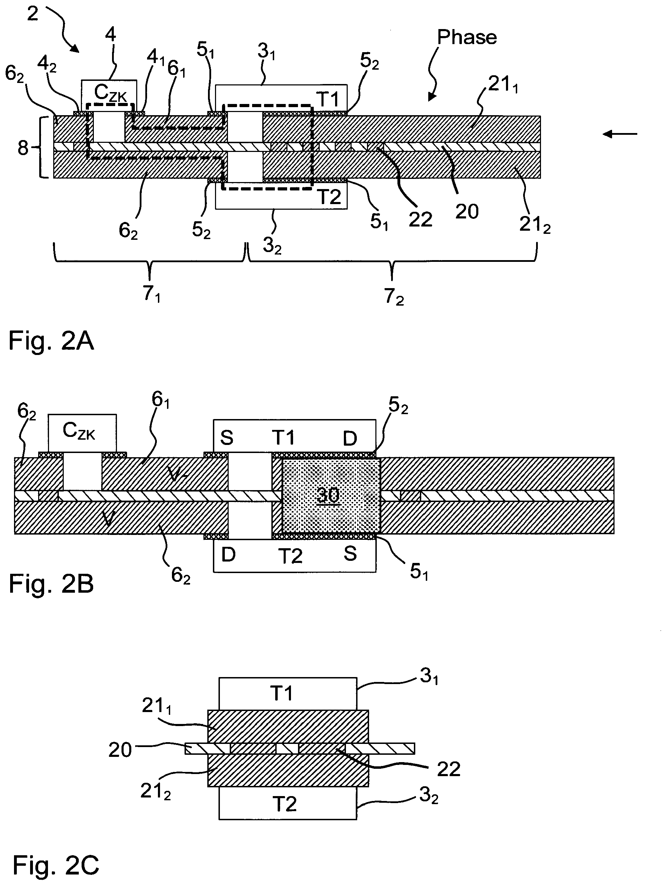

Die Figuren 2A bis 2C zeigen eine teilweise geschnittene Seitenansicht durch die erfindungsgemäße Schaltzelle 2.

Ein Schaltungsträger 8 besteht in diesem Ausführungsbeispiel aus einem Dielektrikum 20 und einer ersten und zweiten Metallisierungsschicht $21_1$, $21_2$, die bevorzugt aus Kupfer bestehen. Das Dielektrikum 20 trennt die beiden Metallisierungsschichten $21_1$ und $21_2$ galvanisch voneinander. Die dielektrische Schicht 20 und die Metallisierungsschichten $21_1$, $21_2$ sind bezüglich ihrer Dicke nicht maßstabsgetreu gezeichnet.

Zumindest zwei Halbleiterschaltelemente $3_1$, $3_2$ sind auf dem Schaltungsträger 8 angeordnet. Ein erstes Halbleiterschaltelement $3_1$ ist auf einer ersten Seite des Schaltungsträgers 8 angeordnet und mit diesem elektrisch leitend verbunden, bevorzugt verlötet. Ein zweites Halbleiterschaltelement $3_2$ ist auf einer zweiten Seite, die der ersten Seite gegenüberliegt, des Schaltungsträgers 8 angeordnet und mit dieser zweiten Seite elektrisch leitend verbunden, beispielsweise verlötet. Der erste Anschlussbereich $5_1$ des ersten Halbleiterschaltelementes $3_1$ ist über die erste elektrische Leitung $6_1$, die in einem ersten Teil $7_1$ des Schaltungsträgers 8 verläuft mit dem ersten Anschluss der Gleichspannungsversorgung 4 verbunden.

Der zweite Anschlussbereich $5_2$ des zweiten Halbleiterschaltelementes $3_2$ ist über die zweite elektrische Leitung $6_2$, die in dem ersten Teil $7_1$ des Schaltungsträgers 8 geführt ist, mit dem zweiten Anschluss $4_2$ der Gleichspannungsversorgung 4 verbunden.

Der zweite Anschlussbereich $5_2$ des ersten Halbleiterschaltelementes $3_1$ und der erste Anschlussbereich $5_1$ des zweiten Halbleiterschaltelementes $3_2$ sind miteinander und mit einem elektrisch leitfähigen zweiten Teil $7_2$ des Schaltungsträgers 8 verbunden. Die Trennlinie des ersten Teils $7_1$ und des zweiten Teils $7_2$ des Schaltungsträgers 8 verläuft bevorzugt senkrecht durch die zumindest beiden Halbleiterschaltelemente $3_1$, $3_2$. Der Schaltungsträger 8 ist allerdings bevorzugt einteilig ausgebildet. Der Wortlaut "erster Teil $7_1$" und "zweiter Teil $7_2$" soll nur verdeutlichen, dass der Schaltungsträger 8 gedanklich z.B. in zwei unterschiedliche räumliche Bereiche unterteilt oder gegliedert werden kann, die verschiedene Funktionen ausüben. In dem ersten Teil $7_1$

verlaufen die elektrischen Leitungen $6_1$, $6_2$ von den Halbleiterschaltelementen $3_1$, $3_2$ zur Gleichspannungsversorgung 4, wohingegen im zweiten Teil $7_2$ die Versorgung des elektrischen Verbrauchers stattfindet und über diesen bevorzugt die Wärme abgeführt wird. Innerhalb des zweiten Teils $7_2$ ist das Dielektrikum 20 optional, wohingegen es in dem ersten Teil $7_1$ zwingend ist.

Gestrichelt dargestellt ist in Figur 2A die Schleifeninduktivität $L_{Schaltzelle}$. Wie bereits erläutert sollte diese Schleifeninduktivität möglichst gering gehalten sein. Dies gelingt unter anderem dadurch, dass der Abstand beider Halbleiterschaltelemente $3_1$, $3_2$ zueinander möglichst klein gehalten wird und andererseits dadurch, dass die Gleichspannungsversorgung 4 in Form einer Zwischenkreiskapazität 4 möglichst nahe an die beiden Halbleiterschaltelemente $3_1$, $3_2$ angeordnet wird. Der Abstand der Zwischenkreiskapazität 4 zu dem Halbleiterschaltelement $3_1$, $3_2$, welches auf der gleichen Seite angeordnet ist wie die Zwischenkreiskapazität 4, beträgt bevorzugt weniger als 10 cm, weiter bevorzugt weniger als 7 cm, weiter bevorzugt weniger als 5 cm, weiter bevorzugt weniger als 2 cm.

Die beiden Metallisierungsschichten $21_1$, $21_2$ sind bevorzugt mittels Dickkupfertechnologie gebildet und weisen eine Schichtdicke von jeweils mehr als 100 $\mu$m, bevorzugt mehr als 200 $\mu$m, weiter bevorzugt mehr als 300 $\mu$m und weiter bevorzugt mehr als 400 $\mu$m, weiter bevorzugt mehr als 800 $\mu$m auf. Zusätzlich können auch die erste und zweite elektrische Leitung $6_1$, $6_2$ mittels dieser Dickkupfertechnologie gebildet sein.

Im zweiten Teil $7_2$ des Schaltungsträgers 8 sind die beiden Metallisierungsschichten $21_1$, $21_2$ galvanisch, bevorzugt über eine Vielzahl von Durchkontaktierungen 22, miteinander verbunden. Diese Durchkontaktierungen 22 verlaufen bevorzugt durch alle Lagen des Schaltungsträgers 8. Diese Durchkontaktierungen 22 befinden sich bevorzugt in der Nähe des zweiten Anschlussbereiches $5_2$ des ersten Halbleiterschaltelementes $3_1$ und des ersten Anschlussbereichs $5_1$ des zweiten Halbleiterschaltelementes $3_2$. Die Durchkontaktierungen 22 sind bevorzugt unterhalb, also beispielsweise zwischen den beiden aufeinander zu weisenden Anschlussbereiche $5_1$, $5_2$ ausgebildet. Dadurch wird nicht nur eine niederohmige Verbindung zwischen den zwei Metallisierungsschichten $21_1$, $21_2$ sichergestellt, gleichzeitig dienen diese Durchkontaktierungen 22 auch dazu, dass ein guter Wärmetransport zwischen beiden Metallisierungsschichten $21_1$, $21_2$ bewerkstelligt wird. Die durch die Schaltverluste entstehende Verlustwärme wird dadurch im gesamten zweiten Teil $7_2$ des Schaltungsträgers 8 verteilt. Sowohl die beiden Halbleiterschaltelemente $3_1$, $3_2$, als auch die beiden Metallisierungsschichten $21_1$, $21_2$, können mit zusätzlichen Kühlkörpern versehen werden, um eine noch effizientere Wärmeabfuhr zu gewährleisten.

Bevorzugt werden mehr als fünf Durchkontaktierungen 22 pro $cm^2$, weiter bevorzugt mehr als 10 Durchkontaktierungen 22 pro $cm^2$, weiter bevorzugt

mehr als 20 Durchkontaktierungen pro $cm^2$ verwendet. Dabei kann die Durchkontaktierungsdichte auch variiert werden. Eine hohe Durchkontaktierungsdichte sollte unterhalb der jeweiligen Anschlussbereiche $5_1$, $5_2$ der Halbleiterschaltelemente $3_1$, $3_2$ ausgebildet sein, wohingegen die Durchkontaktierungsdichte innerhalb des zweiten Teils $7_2$ in Richtung weg von den Halbleiterschaltelementen $3_1$, $3_2$ abnehmen kann.

Figur 2B zeigt einen ähnlichen Aufbau der erfindungsgemäßen Schaltzelle 2 wie Figur 2A. Einige oder alle der Durchkontaktierungen 22 sind durch ein Inlay 30 ersetzt. Diese Inlay 30 besteht bevorzugt aus Kupfer. Der Schaltungsträger 8, in Form einer Leiterplatte 8, weist eine Ausnehmung auf, in welche das Inlay 30 eingesetzt ist. Bevorzugt wird die Ausnehmung ausgestanzt oder ausgefräst. Das Inlay 30 wird bevorzugt eingepresst und/oder eingeklebt. Zumindest ein Teil des zweiten Anschlussbereichs $5_2$ des ersten Halbleiterschaltelementes $3_1$ und/oder des ersten Anschlussbereichs $5_1$ des zweiten Halbleiterschaltelementes $3_2$ sind direkt auf dem Inlay 30 mit diesem elektrisch leitend verbunden, also beispielsweise verlötet. Dies erlaubt eine noch niederohmige Verbindung zwischen beiden Halbleiterschaltelementen $3_1$, $3_2$, bzw. den Metallisierungsschichten $21_1$, $21_2$. Gleichzeitig erfolgt eine bessere Wärmespreizung, was bedeutet, dass die Wärme noch besser auf den gesamten zweiten Teil $7_2$ verteilt werden kann. Das Inlay 30 befindet sich beispielsweise ausschließlich unterhalb des zweiten Anschlussbereiches $5_2$ des ersten Halbleiterschaltelementes $3_1$ und/oder des ersten Anschlussbereichs $5_1$ des zweiten Halbleiterschaltelements $3_2$. Es kann allerdings auch größer ausgebildet sein, so dass es weiter in den zweiten Teil $7_2$ des Schaltungsträgers 8 hineinragt, der nicht von dem ersten und/oder zweiten Halbleiterschaltelement $3_1$, $3_2$ bedeckt ist.

Das Inlay 30 besteht aus einem thermisch und elektrisch sehr gut leitfähigen Material wie beispielsweise Kupfer.

Die erste und/oder zweite elektrische Leitung $6_1$, $6_2$ und/oder die erste und/oder zweite Metallisierungsschicht $21_1$, $21_2$ und/oder das Inlay 30 können zusätzlich mit einer leitfähigen Schicht überzogen, beispielsweise mit Silber galvanisiert sein.

Das erste Halbleiterschaltelement $3_1$ und das zweite Halbleiterschaltelement $3_2$ sind bezüglich ihres ersten und zweiten Anschlussbereiches $5_1$, $5_2$ spiegelsymmetrisch aufgebaut. Dies bedeutet, dass unterschiedliche Anschlussbereiche $5_1$, $5_2$ flächig ausgeführt sind. In dem Ausführungsbeispiel aus Figur 2B ist der zweite Anschlussbereich $5_2$ des ersten Halbleiterschaltelementes $3_1$, bei welchem es sich bevorzugt um den Drain-Anschluss handelt, flächig ausgeführt, wohingegen bei dem zweiten Halbleiterschaltelement $3_2$ der erste Anschlussbereich $5_1$, bei welchem es sich bevorzugt um den Source-Anschluss handelt, flächig ausgeführt ist.

Die erste elektrische Leitung $6_1$ verläuft überwiegend auf der ersten Seite des ersten Teils $7_1$ des Schaltungsträgers 8, wohingegen die zweite elektrische

Leitung $6_2$ überwiegend auf der zweiten Seite des ersten Teils $7_1$ des Schaltungsträgers 8 verläuft. Bei Schaltungsträgern 8, die über mehr als zwei Metallisierungsschichten $21_1$, $21_2$ verfügen, laufen die erste elektrische Leitung $6_1$ und die zweite elektrische Leitung $6_2$ bevorzugt auf verschiedenen Lagen, die möglichst nahe zusammen liegen. Unter dem Begriff "überwiegend" wird verstanden, dass die jeweilige elektrische Leitung $6_1$, $6_2$ bezüglich ihrer Länge zum größeren Teil, also bevorzugt zu mehr als 50%, weiter bevorzugt zu mehr als 60%, weiter bevorzugt zu mehr als 70%, weiter bevorzugt zu mehr als 80%, weiter bevorzugt zu mehr als 90% auf der Seite, bzw. auf der Lage des Schaltungsträgers 8 verläuft, auf der die jeweils andere elektrische Leitung $6_1$, $6_2$ nicht überwiegend angeordnet ist. Die beiden elektrischen Leitungen $6_1$, $6_2$ verlaufen daher bevorzugt überwiegend auf getrennten Lagen.

Figur 2C zeigt eine Draufsicht auf die erfindungsgemäße Schaltzelle 2 in Richtung des in Figur 2A eingezeichneten Pfeils. Zu erkennen sind die Durchkontaktierungen 22, die beiden Metallisierungsschichten $21_1$, $21_2$ und die beiden Halbleiterschaltelemente $3_1$, $3_2$. Die beiden Halbleiterschaltelemente $3_1$, $3_2$ sind deckungsgleich übereinander, allerdings auf verschiedenen Seiten des Schaltungsträgers 8 angeordnet. Aufgrund dieser Symmetrie können die Schleifeninduktivität und die Kapazitäten $C1_{Aufbau}$ und $C2_{Aufbau}$ stark reduziert werden.

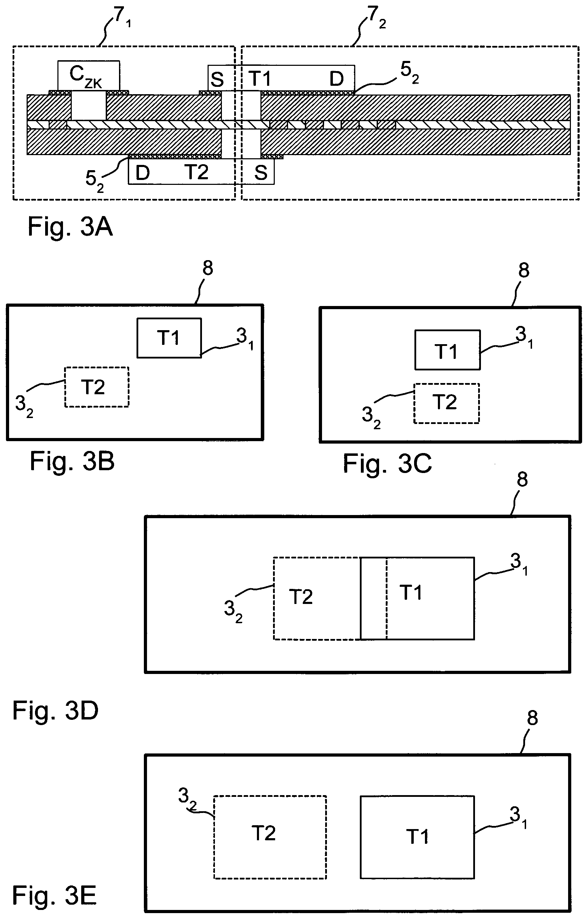

Die Figur 3A zeigt eine teilweise geschnittene Seitenansicht durch die erfindungsgemäße Schaltzelle 2, wobei die beiden Halbleiterschaltelemente $3_1$, $3_2$ nicht deckungsgleich zueinander angeordnet sind. Innerhalb von Figur 3A sind die Halbleiterschaltelemente $3_1$, $3_2$ nicht spiegelsymmetrisch aufgebaut. Dies bedeutet, dass jeweils die gleichen Anschlussbereiche $5_2$ flächig ausgeführt sind und sich zur Wärmeabfuhr eignen. Sowohl bei dem ersten Halbleiterschaltelemente $3_1$, als auch bei dem zweiten Halbleiterschaltelement $3_2$ sind die zweiten Anschlussbereiche $5_2$, also die Drain-Anschlüsse, flächig ausgeführt. Der Drain-Anschluss des zweiten Halbleiterschaltelementes $3_2$ ist auf der zweiten Seite im ersten Teil $7_1$ des Schaltungsträgers 8 angeordnet. Der Drain-Anschluss des ersten Halbleiterschaltelementes $3_1$ ist dagegen im zweiten Teil $7_2$ auf der ersten Metallisierungslage $21_1$ des Schaltungsträgers 8 angeordnet. Dies bedeutet, dass die Wärmeabfuhr sowohl im ersten Teil $7_1$, als auch im zweiten Teil $7_2$ des Schaltungsträgers 8 gewährleistet sein muss.

Dadurch, dass die Halbleiterschaltelemente $3_1$, $3_2$ versetzt zueinander angeordnet sind, erfolgt Wärmeabfuhr nicht nur in Längsrichtung des zweiten Teils $7_2$, sondern auch quer zur Längsrichtung des zweiten Teils $7_2$ des Schaltungsträgers 8.

Die Figuren 3B, 3C, 3D und 3E zeigen eine prinzipielle Anordnung der Halbleiterschaltelemente $3_1$, $3_2$ zueinander und erläutern, wie stark sich die zumindest beiden Halbleiterschaltelemente $3_1$, $3_2$ überlappen können. Das erste Halbleiterschaltelement $3_1$ befindet sich auf der ersten Seite des Schaltungsträgers 8. Das zweite Halbleiterschaltelement $3_2$ befindet sich auf der zweiten Seite des Schaltungsträgers 8 und ist daher in gestrichelter Form dargestellt. Innerhalb der Figuren 3B, 3C und 3E überlappen sich die Halbleiterschaltelemente $3_1$, $3_2$ nicht und so kann räumlich neben dem ersten Halbleiterschaltelement $3_1$ auf der gleichen Seite des Schaltungsträgers 8 und neben dem zweiten Halbleiterschaltelement $3_2$ ein Kühlkörper montiert werden, der nicht nur die Wärme des jeweils benachbarten, auf der gleichen Seite angeordneten Halbleiterschaltelementes $3_1$, $3_2$ aufnimmt, sondern auch diejenige, die von dem auf der gegenüberliegenden Seite angeordneten Halbleiterschaltelementes $3_1$, $3_2$ dissipiert wurde.

Innerhalb von Figur 3B überlappen sich die Halbleiterschaltelemente $3_1$, $3_2$ nicht und sind diagonal versetzt zueinander angeordnet. Innerhalb von Figur 3C überlappen sich die Halbleiterschaltelemente $3_1$, $3_2$ ebenfalls nicht und sind bezüglich ihrer Seitenfläche parallel beabstandet zueinander angeordnet, wobei sie in einer Flur ausgerichtet sind. Innerhalb von Figur 3E überlappen sich bei der Draufsicht auf die erste Seite des Schaltungsträgers 8 das erste Halbleiterschaltelement $3_1$ und das zweite Halbleiterschaltelement $3_2$ nicht. Sie sind vielmehr bezüglich ihrer Stirnseite beabstandet voneinander, aber dennoch parallel zueinander angeordnet.

Innerhalb von Figur 3D überlappen sich die Halbleiterschaltelemente $3_1$, $3_2$ teilweise. Bei einer Draufsicht auf die erste Seite des Schaltungsträgers 8 überlappen sich das erste Halbleiterschaltelement $3_1$ und das zweite Halbleiterschaltelement $3_2$ zu mehr als 20%, bevorzugt zu mehr als 30%, weiter bevorzugt zu mehr als 40%, weiter bevorzugt zu mehr als 50%, weiter bevorzugt zu mehr als 60%, weiter bevorzugt zu mehr als 70%, weiter bevorzugt zu mehr als 80%, weiter bevorzugt zu mehr als 90%, aber zu weniger als 95%.

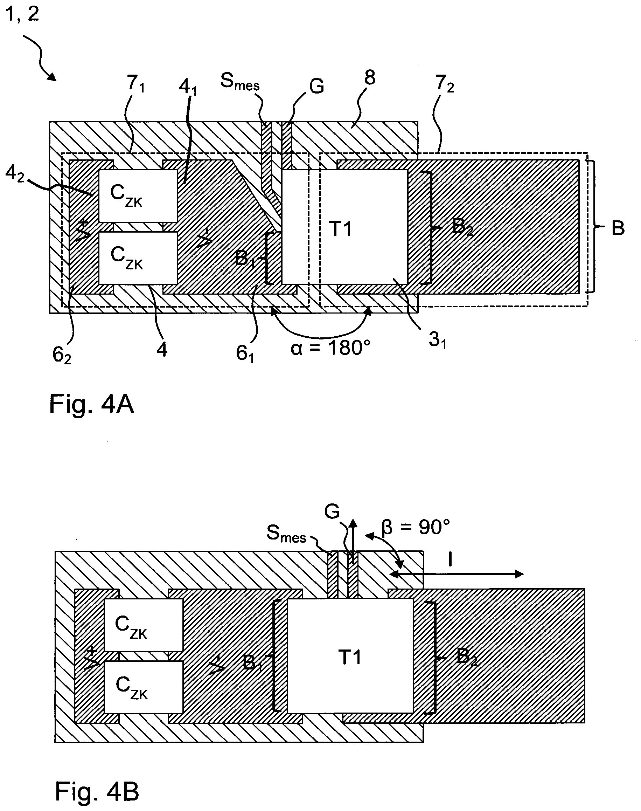

Die Figuren 4A und 4B zeigen eine Draufsicht auf die erste Seite der erfindungsgemäßen Schaltzelle 2. Der erste Teil $7_1$ und der zweite Teil $7_2$ des Schaltungsträgers 8 bilden einen Winkel von $\alpha = 180°$ zueinander.

Der zweite Teil $7_2$ des Schaltungsträgers 8 weist eine Breite B auf, die mindestens 90% der Breite $B_2$ des zweiten Anschlussbereichs $5_2$ des ersten Halbleiterschaltelements $3_1$ oder des ersten Anschlussbereichs $5_1$ des zweiten Halbleiterschaltelementes $3_2$ entspricht. Die Breite B des zweiten Teils $7_2$ kann daher kleiner sein, als die Breite $B_2$ des zweiten Anschlussbereichs $5_2$. Bevorzugt ist sie allerdings größer als die Breite $B_2$ des zweiten Anschlussbereichs $5_2$, wie dies auch in Figur 4A dargestellt ist.

Gleiches gilt auch für die erste elektrische Leitung $6_1$ und/oder die zweite elektrische Leitung $6_2$. Diese weisen mindestens ebenfalls 90% der Breite $B_1$ des ersten Anschlussbereiches $5_1$ des ersten Halbleiterschaltelementes $3_1$ oder des zweiten Anschlussbereiches $5_2$ des zweiten Halbleiterschaltelementes $3_2$ auf. Wie bereits erläutert kann die Schleifeninduktivität $L_{Schaltzelle}$

dadurch reduziert werden, indem die erste und/oder zweite elektrische Leitung $6_1$, $6_2$ möglichst breit ausgeführt sind. Die erste und/oder zweite elektrische Leitung $6_1$, $6_2$ fächert sich außerhalb des ersten Anschlussbereichs $5_1$ des ersten Halbleiterschaltelementes $3_1$ oder außerhalb des zweiten Anschlussbereiches $5_2$ des zweiten Halbleiterschaltelements $3_2$ auf eine Breite von bevorzugt mehr als das Doppelte, weiter bevorzugt auf mehr als das Dreifache der Breite $B_1$ des ersten Anschlussbereichs $5_1$ des Halbleiterschaltelementes $3_1$ oder des zweiten Anschlussbereiches $5_2$ des zweiten Halbleiterschaltelementes $3_2$ auf. Die erste elektrische Leitung $6_1$, und/oder die zweite elektrische Leitung $6_2$ können die Form eines "L" haben. Die weiteren Leitungen, die zum Steuer-Anschluss $S_{mes}$ und zum Gate-Anschluss des jeweiligen Halbleiterschaltelementes $3_1$, $3_2$ führen, sind zumindest teilweise orthogonal mit $\beta{\sim}90°$ zur Hauptstromrichtung der ersten und/oder zweiten elektrischen Leitung $6_1$, $6_2$ geführt. Die Breite $B_1$ des ersten Anschlussbereiches $5_1$ des ersten Halbleiterschaltelementes und/oder des zweiten Anschlussbereiches $5_2$ des zweiten Halbleiterschaltelementes $3_2$ entspricht bevorzugt mehr als 50% der Gesamtbreite des ersten und/oder zweiten Halbleiterschaltelementes $3_1$, $3_2$.

Innerhalb des Ausführungsbeispiels aus Figur 4B ist die erste elektrische Leitung $6_1$ in Form eines Recktecks ausgeführt. Die Länge der ersten elektrischen Leitung $6_1$ entspricht ungefähr der Breite der ersten elektrischen Leitung $6_1$. Die erste elektrische Leitung $6_1$ ist breiter als die Breite des jeweiligen Halbleiterschaltelementes $3_1$, $3_2$. Der Steuer-Anschluss $S_{mes}$ und der Gate-Anschluss des Halbleiterschaltelementes $3_1$, $3_2$ werden zentral, also im Zentrum des Halbleiterschaltelementes $3_1$, $3_2$ aus diesem herausgeführt. Dies bedeutet, dass sowohl der erste Anschlussbereich $5_1$, als auch der zweite Anschlussbereich $5_2$ des jeweiligen Halbleiterschaltelementes $3_1$, $3_2$ über die gesamte Breite entlang des jeweiligen Halbleiterschaltelementes $3_1$, $3_2$ angeordnet ist.

Es besteht bevorzugt keine direkte Verbindung zwischen dem zweiten Teil $7_2$ und einer Massefläche, also beispielsweise dem geerdeten metallischen Gehäuse der Schaltzellenanordnung 1.

Die erste elektrische Leitung $6_1$ und die zweite elektrische Leitung $6_2$ sind über zumindest eine Zwischenkreiskapazität 4 miteinander verbunden. Bevorzugt sind die beiden elektrischen Leitungen $6_1$, $6_2$ über zwei, weiter bevorzugt über drei, weiter bevorzugt über mehr als vier Zwischenkreiskapazitäten 4 miteinander verbunden. Jede Schaltzelle 2 weist daher eine, bevorzugt zwei, weiter bevorzugt drei, weiter bevorzugt mehr als drei Zwischenkreiskapazitäten 4 auf.

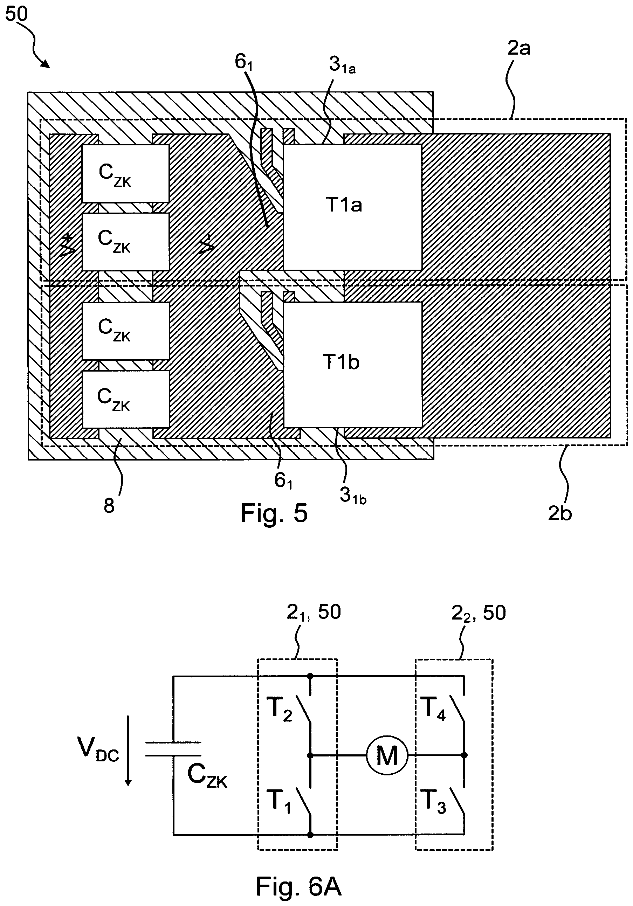

Figur 5 zeigt eine Draufsicht auf eine Seite eines Schaltzellenparallelblocks 50, der aus zumindest zwei parallel geschalteten erfindungsgemäßen Schaltzellen 2a, 2b besteht. Die zumindest zwei erfindungsgemäßen Schaltzellen 2 teilen sich bevorzugt den Schaltungsträger 8. Dies bedeutet, dass beide Schaltzellen 2a, 2b das gleiche Dielektrikum 20 aufweisen. Die erste elektrische Leitung $6_1$ der ersten Schaltzelle 2a ist mit der ersten elektrischen Leitung $6_1$ der zweiten Schaltzelle 2b galvanisch verbunden. Bei dieser Verbindung handelt es sich bevorzugt um eine flächige und um keine punktuelle Verbindung. Die beiden ersten elektrischen Leitungen $6_1$ sind bevorzugt über eine Breite miteinander verbunden, die mindestens 50% der Breite des entsprechenden Halbleiterschaltelementes $3_1$, $3_2$ entspricht. Gleiches gilt auch für die jeweiligen zweiten elektrischen Leitungen $6_2$ der ersten und der zumindest einen weiteren Schaltzelle 2a, 2b.

Ebenfalls sind die ersten und zweiten Metallisierungsschichten $21_1$, $21_2$ im zweiten Teil $7_2$ jeder der zumindest zwei Schaltzellen 2a, 2b miteinander bevorzugt flächig verbunden. Weiter bevorzugt sind diese einteilig, beispielsweise in Form eines Rechtecks, ausgebildet.

Damit ein solcher Schaltzellenparallelblock 50 ordnungsgemäß funktioniert, muss sichergestellt sein, dass die jeweils zueinander korrespondierenden ersten und zweiten Halbleiterschaltelemente $3_1$, $3_2$ in den verschiedenen Schaltzellen 2a, 2b zu den gleichen Zeitpunkten ein- und ausschalten. Dies wird dadurch erreicht, dass die beiden Gate-Anschlussleitungen der Halbleiterschaltelemente $3_{1a}$ und $3_{1b}$ gleichlang sind. Die beiden Gate-Anschlüsse der Halbleiterschaltelemente $3_{1a}$, $3_{1b}$ werden miteinander verbunden, wobei z.B. in der Mitte dieser Verbindung eine Gate-Anschlussleitung einem entsprechenden Treiber zugeführt ist. Gleiches gilt auch für die zweiten (nicht dargestellten) Halbleiterschaltelemente $3_{2a}$, $3_{2b}$ die auf der anderen Seite des Schaltungsträgers 8 angeordnet sind. Die Gate-Anschlussleitungen sollten dabei im 90°-Winkel zur Stromrichtung im Leistungsteil der erfindungsgemäßen Schaltzelle 2a, 2b geführt sein um induktive Kopplungen zu unterdrücken.

Eine einzelne erfindungsgemäße Schaltzelle 2 oder ein Schaltzellenparallelblock 50 stellt die Basis für komplexe Topologien dar. Durch Kombination mehrerer Schaltzellen 2 oder mehrerer Schaltzellenparallelblöcke 50 werden vielseitige Einsatzbereiche erschlossen. Hierzu zählen beispielsweise die Ansteuerung von Gleich- und Drehstrommotoren und alle bekannten hart schaltenden Grundtopologien für Schaltnetzteile, wie zum Beispiel Buck oder Boost. Des Weiteren können die Schaltzellen 2 oder Schaltzellenparallelblöcke 50 zur aktiven Gleichrichtung von Wechsel- und Drehspannungssystemen verwendet werden.

Figur 6A zeigt, wie durch eine Parallelschaltung von zwei Schaltzellen 2 oder zwei Schaltzellenparallelblöcke 50 eine Vollbrücke entsteht. Diese kann beispielsweise für Motorsteuerungen von Gleichstrommaschinen verwendet werden. Es ist allerdings auch möglich diese Schaltungskombination als aktiv gesteuerten Gleichrichter zu verwenden. Die jeweils ersten elektrischen Leitungen $6_1$ jeder Schaltzelle $2_1$, $2_2$ oder jedes Schaltzellenparallelblocks 50 sind miteinander verbunden. Gleichzeitig sind die jeweils zweiten elektrischen Leitungen $6_2$ jeder Schaltzelle $2_1$, $2_2$ oder jedes Schaltzellenparallelblocks 50 miteinander verbunden. Der zweite Teil $7_2$ der ersten Schaltzelle $2_1$ oder des ersten Schaltzellenparallelblocks 50 ist mit einem ersten Anschluss einer elektrischen Maschine verbunden, wohingegen der zweite Teil $7_2$ der zweiten Schaltzelle $2_2$ oder des zweiten Schaltzellenparallelblocks 50 mit einem zweiten Anschluss der elektrischen Maschine verbunden ist, so dass die beiden Schaltzellen $2_1$, $2_2$ oder die beiden Schaltzellenparallelblöcke 50 als Vollbrücke betrieben werden. Dabei darf natürlich nur ein Halbleiterschaltelement $3_1$, $3_2$ in jeder Schaltzelle $2_1$, $2_2$ zum gleichen Zeitpunkt betätigt sein, ansonsten würde ein Kurzschluss entstehen. Eine Totzeit stellt sicher, dass ein Halbleiterschaltelement $3_1$, $3_2$ erst dann eingeschalten wird, wenn das andere Halbleiterschaltelement $3_2$, $3_1$ einen Ausschaltbefehl bereits für die Dauer der Totzeit erhalten hat. Die Verzögerungen beim Einschalten werden durch den nicht dargestellten Treiber realisiert.

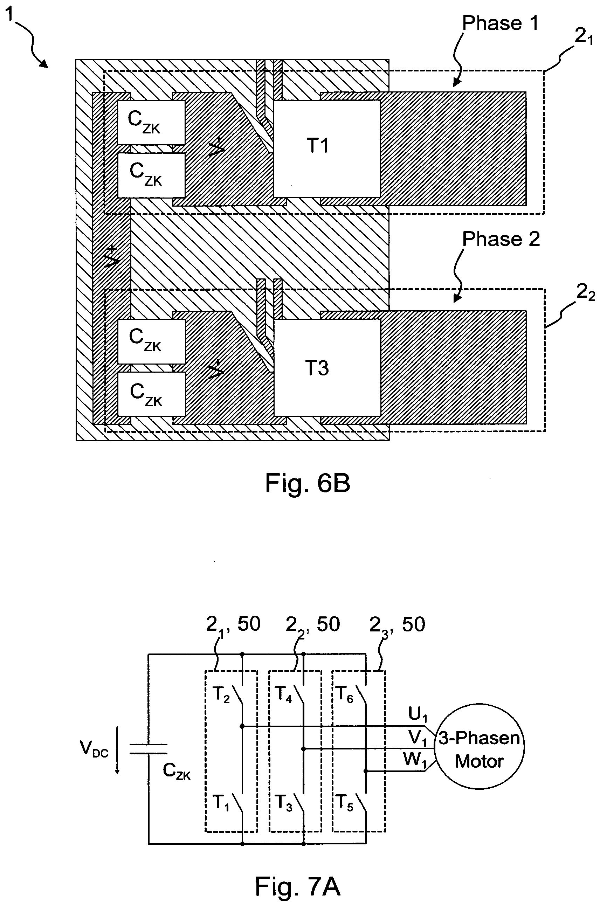

Figur 6B zeigt eine Draufsicht auf eine erste Seite, der aus zwei erfindungsgemäßen Schaltzellen $2_1$, $2_2$ bestehenden Vollbrücke. Die beiden Schaltzellen $2_1$, $2_2$ oder die beiden Schaltzelleprallelblöcke 50 sind bevorzugt auf einem gemeinsamen Schaltungsträger 8 ausgebildet. Es ist auch möglich, dass die beiden Schaltzellen $2_1$, $2_2$ oder die beiden Schaltzellenparallelblöcke 50 auf verschiedenen Schaltungsträgern 8 ausgebildet sind und mittels Abstandshaltung übereinander angeordnet werden. Zusätzlich zu den Abstandhaltern muss über ein elektrisch leitendes Verbindungsmittel sichergestellt werden, das die jeweils ersten Leitungen $6_1$ und die jeweils zweiten Leitungen $6_2$ jeder Schaltzelle $2_1$, $2_2$ oder jedes Schaltzellenparallelblocks 50 miteinander verbunden sind.

Die am meisten einsetzte Topologie zur Regelung von Drehstrommotoren kann jedenfalls durch Parallelschaltung der erfindungsgemäßen Schaltzellen 2 vorgenommen werden. Dazu müssen drei Schaltzellen $2_1$, $2_2$, $2_3$ parallel geschaltet werden. Wie die Vollbrücke kann auch das Dreiphasen-Halbbrücken-System zur aktiven Gleichrichtung eines Drehspannungssystems verwendet werden.

Figur 7A zeigt ein solches Prinzipschaltbild eines aus drei erfindungsgemäßen Schaltzellen $2_1$, $2_2$, $2_3$ bestehenden dreiphasigen Umrichters.

Der Aufbau entspricht im Wesentlichen der Vollbrücke aus Figur 6A.

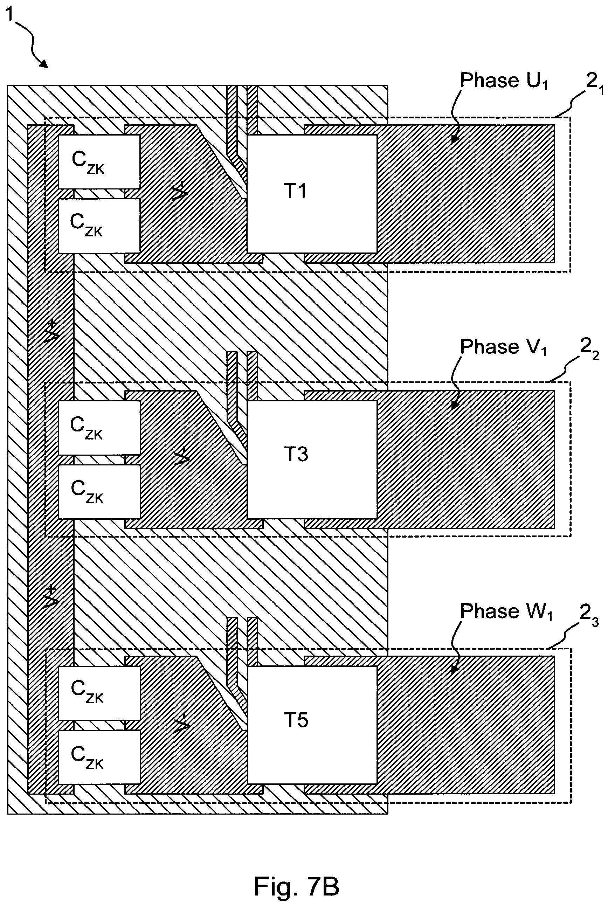

Figur 7B zeigt eine Draufsicht auf einen solchen dreiphasigen Umrichter, der aus drei erfindungsgemäßen Schaltzellen $2_1$, $2_2$, $2_3$ besteht. Die ersten Leitungen $6_1$ jeder Schaltzelle $2_1$, $2_2$, $2_3$ sind galvanisch miteinander verbunden. Gleiches gilt auch für die zweiten elektrischen Leitungen $6_2$. Der jeweils zweite Teil $7_2$ jeder Schaltzelle $2_1$, $2_2$, $2_3$ wird je einem Eingangsanschluss der elektrischen Maschine zugeführt. Die drei Schaltzellen $2_1$, $2_2$, $2_3$ können auf dem gleichen Schaltungsträger 8 ausgebildet sein. Es ist allerdings auch möglich, dass

die drei Schaltzellen $2_1$, $2_2$, $2_3$ jeweils auf ihrem eigenen Schaltungsträger 8 ausgebildet sind, wobei die drei Schaltzellen $2_1$, $2_2$, $2_3$ mittels Abstandshaltern übereinander angeordnet werden.

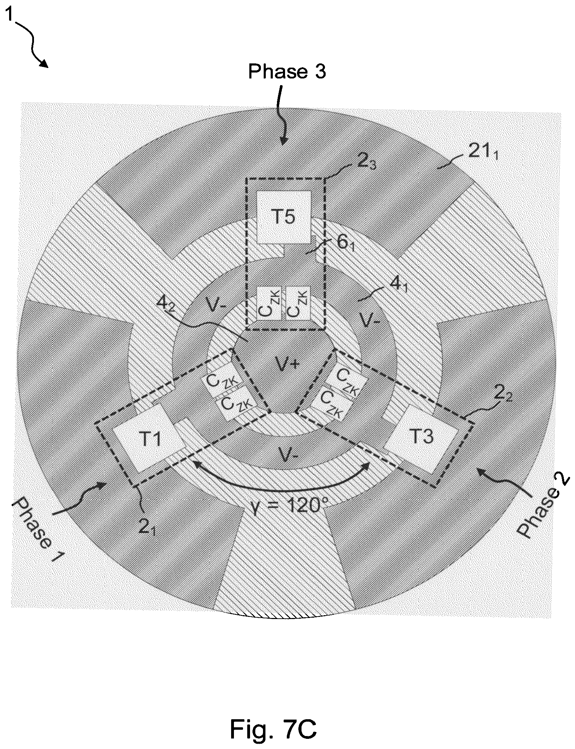

Figur 7C zeigt eine bevorzugte Ausführungsform des dreiphasigen Umrichters. Der zweite Anschluss $4_2$ der Gleichspannungsversorgung 4 ist im Zentrum eines bevorzugt kreisrunden Schaltungsträgers 8 angeordnet, bzw. er bildet das Zentrum. Der zweite Anschluss $4_2$ ist dabei bevorzugt zumindest teilweise rund, d.h. z. B. scheiben-, ring- oder kreisförmig ausgeführt. Radial hierzu beabstandet ist der erste Anschluss $4_1$ der Gleichspannungsversorgung 4 angeordnet. Dieser erste Anschluss $4_1$ ist ebenfalls rund, bzw. überwiegend rund ausgeführt und weist die Form eines Hohlkreises bzw. einer umlaufenden ring- und/oder rahmenförmigen Fläche auf. Diese umlaufende insbesondere ringförmige Fläche verbindet die ersten elektrischen Leitungen $6_1$ aller ausgebildeten Schaltzellen $2_1$, $2_2$, $2_3$, $2_n$ miteinander.

Im Inneren dieser umlaufenden ringförmigen Fläche des ersten Anschlusses ist der zweite Anschluss $4_2$ galvanisch getrennt vom ersten Anschluss $4_1$ der Gleichspannungsversorgung 4 angeordnet. Die zweiten elektrischen Leitungen $6_2$ aller ausgebildeten Schaltzellen $2_1$, $2_2$, $2_3$, $2_n$ sind auf der nicht dargestellten zweiten Seite des Schaltungsträgers 8 oder auf einer nicht dargestellten zweiten Lage des mehrlagigen Schaltungsträgers 8 miteinander und über Durchkontaktierungen mit dem auf der ersten Seite des Schaltungsträgers 8 ausgebildeten zweiten Anschlusses $4_2$ verbunden. Nicht dargestellt ist ebenfalls der Anschluss an eine externe Energieversorgungsquelle, wie beispielsweise ein Netzteil.

Die zumindest drei Schaltzellen $2_1$, $2_2$, $2_3$ oder die zumindest drei Schaltzellenparallelblöcke 50 sind derart auf dem Schaltungsträger 8 angeordnet, dass sie sich vom Zentrum radial nach außen erstrecken oder dass sie vom Zentrum mit einem bestimmten Abstand beabstandet sind und sich von dort aus radial nach außen erstrecken, wobei jede der zumindest drei Schaltzellen $2_1$, $2_2$, $2_3$ oder jede der zumindest drei Schaltzellenzellenprallelblöcke 50 zu seiner benachbarten Schaltzelle $2_1$, $2_2$, $2_3$ oder zu seinem benachbarten Schaltzellenparallelblock 50 einen Winkel von $\gamma = \frac{360°}{n}$ bildet. Dies bedeutet, dass eine Gerade, die in Längsrichtung durch die Schaltzelle $2_1$, $2_2$, $2_3$ verläuft, sich mit der Geraden, die durch die benachbarte Schaltzelle $2_1$, $2_2$, $2_3$ verläuft unter einem Winkel von $\gamma = \frac{360°}{n}$ = durch n schneidet, wobei n die Anzahl der Schaltzellen $2_1$, $2_2$, $2_3$ auf dem Substrat 8 darstellt. Dabei ist die Fläche der ersten elektrischen Leitung $6_1$ und/oder der zweiten elektrischen Leitung $6_2$ kleiner als die Fläche der Metallisierungsschichten $21_1$, $21_2$ im zweiten Teil $7_2$ des Schal-

tungsträgers 8. Gleiches gilt auch für die Fläche des ersten Anschlusses $4_1$ und die Fläche des zweiten Anschlusses $4_2$.

Die Metallisierungsschichten $21_1$, $21_2$ spreizen sich in dem Ausführungsbeispiel aus Figur 7C sehr stark auf und haben die Form eines Kreisringsegments, sodass auch der zweite Teil $7_2$ die Form eines Kreisringsegments besitzt. Der zweite Teil $7_2$ ist größer als der erste Teil $7_1$ des Schaltungsträgers 8. Der zweite Teil $7_2$ kann auch als Phasenausgang bezeichnet werden.

Unter Verwendung von drei Schaltzellen $2_1$, $2_2$, $2_3$ oder drei Schaltzellenparallelblöcken 50 weisen die Metallisierungsschichten $21_1$, $21_2$ jeder der drei Schaltzellen $2_1$, $2_2$, $2_3$ oder jeder der drei Schaltzellenparallelblöcke 50 eine größere Fläche auf, als alle ersten Leitungen $6_1$ und alle zweiten Leitungen $6_2$ zusammen. Bevorzugt ist die Fläche auch noch größer als die Fläche des ersten und zweiten Anschlusses $4_1$, $4_2$. Dies gilt allerdings nur dann, wenn die Schaltverluste des ersten und zweiten Halbleiterschaltelements $3_1$, $3_2$ auf jeder der drei Schaltzellen $2_1$, $2_2$, $2_3$ oder jeder der drei Schaltzellenparallelblöcke 50 überwiegend über den zweiten Teil $7_2$ abgeführt werden.

Die Fläche zwischen den Metallisierungsschichten $21_1$, $21_2$ eines ersten Schaltelements $2_1$, $2_2$, $2_3$, $2_n$ zu den Metallisierungsschichten $21_1$, $21_2$ eines zum ersten Schaltelement $2_1$, $2_2$, $2_3$, $2_n$ benachbarten weiteren Schaltelements $2_1$, $2_2$, $2_3$, $2_n$ ist bevorzugt kleiner als die Fläche der jeweiligen Metallisierungsschichten $21_1$, $21_2$. Gleichzeitig ist die Fläche zwischen den Metallisierungsschichten $21_1$, $21_2$ eines Schaltelements $2_1$, $2_2$, $2_3$, $2_n$ zu der umlaufenden ringförmigen Fläche des ersten Anschlusses $4_1$ kleiner als die Fläche der jeweiligen Metallisierungsschicht $21_1$, $21_2$.

In einem nicht dargestellten Ausführungsbeispiel befindet sich der erste Anschluss $4_1$ der Gleichspannungsversorgung im Zentrum eines bevorzugt runden Schaltungsträgers 8 auf dessen erster Seite, wohingegen der zweite Anschluss $4_2$ der Gleichspannungsversorgung 4 im Zentrum des Schaltungsträgers auf der zweiten Seite angeordnet ist. Die beiden Seiten können beispielsweise über eine Zwischenkreiskapazität 4 in Form eines Drucksteckkondensators verbunden werden. Zwei dieser in Figur 7c gezeigten Schaltzellenanordnungen können übereinander gestapelt werden, wobei sie bevorzugt mittels Abstandshaltern zueinander beabstandet sind. Die Strompfade vom zweiten Teil $7_2$ einer Schaltzelle $2_1$, $2_2$, $2_3$ über die elektrischen Maschine hin zum zweiten Teil $7_2$ einer anderen Schaltzelle $7_1$, $7_2$, $7_3$ sind dabei für alle Schaltkombinationen gleich lang, was zu einem symmetrischen Aufbau führt.

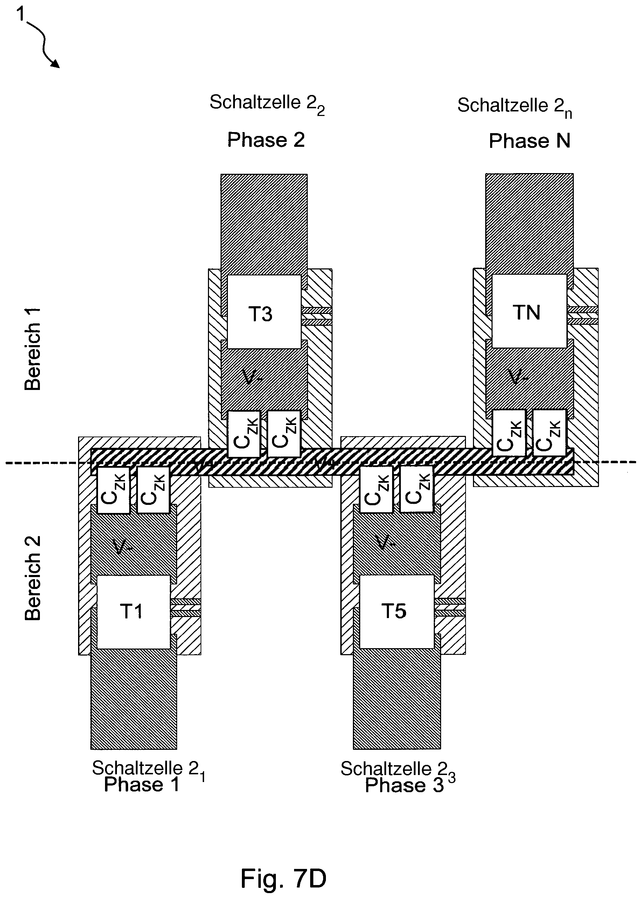

Figur 7D zeigt eine Draufsicht auf eine Seite eines aus n erfindungsgemäßen Schaltzellen $2_1$, $2_2$, $2_3$, $2_n$ bestehenden n-phasigen Umrichters. Eine Erweiterung des drei-Phasen-Systems auf ein n-Phasen-System macht hohe Ausgangsleistungen möglich, weil die Phasenströme mit der Phasenanzahl reduziert werden können. Die in Figur 7D dargestellte Schaltzellenanordnung 1 besteht aus n-Schaltzellen $2_1$, $2_2$, $2_3$, $2_n$ oder aus n-Schaltzellenparallelblöcken 50, wobei gilt

$$n > 2 \; und \; n \in \mathbb{N}.$$

Dabei sind wie immer die jeweils ersten elektrischen Leitungen $6_1$ jeder der n-Schaltzellen $2_1$, $2_2$, $2_3$, $2_n$ oder jeder der n-Schaltzellenprallelblöcke 50 miteinander verbunden. Gleiches gilt ebenfalls für die jeweils zweiten elektrischen Leitungen $6_2$. Der zweite Teil $7_2$ jeder der n-Schaltzellen $2_1$, $2_2$, $2_3$, $2_n$ oder jeder der n-Schaltzellenprallelblöcke 50 ist mit einem der n-Anschlüsse der elektrischen Maschine verbindbar oder verbunden. Die n-Schaltzellen $2_1$, $2_2$, $2_3$, $2_n$ oder die n-Schaltzellenparallelblöcke 50 sind bevorzugt einem gemeinsamen Schaltungsträger 8 ausgebildet, wobei die Gleichspannungsversorgung in Form einer Leitung den Schaltungsträger in bevorzugt zwei gleichgroße Bereiche teilt, wobei die $(2 \cdot (n-2))$-Schaltzelle $2_2$, $2_n$ oder der **$(2 \cdot (n-2))$**-Schaltzellenparallelblock 50 orthogonal zu der Gleichspannungsversorgungsleitung ausgebildet und mit dieser verbunden sind und untereinander voneinander beabstandet in dem ersten Bereich angeordnet sind und wobei die **$((2 \cdot (n-2))-1)$**-Schaltzelle $2_1$, $2_3$, $2_n$ oder der **$((2 \cdot (n-2))-1)$**-Schaltzellenprallelblock 50 orthogonal zu der Gleichspannungsversorgungsleitung ausgebildet und mit dieser verbunden sind und untereinander voneinander beabstandet in dem zweiten Bereich angeordnet sind. Diese bedeutet, dass alle gerade Phasenanschlüsse in dem ersten Bereich und alle ungeraden Phasenanschlüsse in dem zweiten Bereich ausgebildet sind. Die n-Schaltzahlen $2_1$, $2_2$, $2_3$, $2_n$ oder die n-Schaltzellenparallelblöcke 50 können auch mittels Abstandshalter übereinander angeordnet sein.

Mittels der Erfindung ist es auch möglich, einen Umrichter zu schaffen, der eine Wechselspannung mit einer ersten Frequenz gleichrichtet und die Gleichspannung in eine Wechselspannung mit einer zweiten Frequenz wechselrichtet, wobei beide Frequenzen gleich oder voneinander verschieden sein können. Je nach Anzahl der Phasen können beispielsweise zwei Vollbrücken gemäß Figur 6A verwendet werden, wobei eine Vollbrücke zur Gleichrichtung einer ersten Wechselspannung dient und die zweite Vollbrücke zur Wechselrichtung dieser Gleichspannung verwendet werden kann. Ein solches System würde einen Energiefluss in beide Richtungen erlauben. Die Energie, die beispielsweise von einer elektrischen Maschine, die im Generatorbetrieb arbeitet, erzeugt wird, könnte dadurch wieder in das Netz zurückgespeist werden. Ein solcher Umrichter kann natürlich auch dreiphasig oder n-phasig aufgebaut werden und neben den n-Schaltzellen $2_1$, $2_2$, $2_3$, $2_n$ auch aus n-Schaltzellenprallelblöcken 50 bestehen.

Bei einem ersten Anschluss $4_1$ der Gleichspannungsversorgung 4 handelt es sich bevorzugt um einen Minus-Pol. Bei dem zweiten Anschluss $4_2$ der Gleichspannungsversorgung 4 handelt es sich bevorzugt um einen Plus-Pol.

Bevorzugt wird der überwiegende Teil der Verlustleistung, also mehr als 50% der Verlustleistung, bevorzugt mehr als 60% der Verlustleistung, weiter bevorzugt mehr als 70% der Verlustleistung, weiter bevorzugt mehr als 80% der Verlustleistung, weiter bevorzugt mehr als 90% der Verlustleistung, aber bevorzugt weniger als 100% der Verlustleistung über den zweiten Teil $7_2$, also den Phasenausgang in Form von Wärme abgeführt.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

**Patentansprüche**

1. Schaltzellenanordnung (1) mit zumindest einer Schaltzelle (2, $2_1$, $2_2$, $2_3$), wobei die zumindest eine Schaltzelle (2, $2_1$, $2_2$, $2_3$) folgende Merkmale umfasst:

   - einen Schaltungsträger (8);
   - zumindest zwei Halbleiterschaltelemente ($3_1$, $3_2$), wobei ein erstes Halbleiterschaltelement ($3_1$) auf einer ersten Seite des Schaltungsträgers (8) angeordnet und mit diesem elektrisch leitend verbunden ist und wobei ein zweites Halbleiterschaltelement ($3_2$) auf einer zweiten, der ersten Seite gegenüberliegenden Seite des Schaltungsträgers (8) angeordnet und mit diesem elektrisch leitend verbunden ist;
   - ein erster Anschlussbereich ($5_1$) des ersten Halbleiterschaltelements ($3_1$) ist über eine erste elektrische Leitung ($6_1$) in einem ersten Teil ($7_1$) des Schaltungsträgers (8) mit einem ersten Anschluss ($4_1$) einer Gleichspannungsversorgung (4) verbunden;
   - ein zweiter Anschlussbereich ($5_2$) des zweiten Halbleiterschaltelements ($3_2$) ist über eine zweite elektrische Leitung ($6_2$) in dem ersten Teil ($7_1$) des Schaltungsträgers (8) mit einem zweiten Anschluss ($4_2$) der Gleichspannungsversorgung (4) verbunden;
   - ein zweiter Anschlussbereich ($5_2$) des ersten Halbleiterschaltelements ($3_1$) und ein erster Anschlussbereich ($5_1$) des zweiten Halbleiterschaltelements ($3_2$) sind miteinander und mit einem elektrisch leitfähigen zweiten Teil ($7_2$) des Schaltungsträgers (8) verbunden;

   **gekennzeichnet durch** die folgenden Merkmale:

   - die erste elektrische Leitung ($6_1$) und die zweite elektrische Leitung ($6_2$) sind über zumindest eine Zwischenkreiskapazität (4), die der Gleichspannungsversorgung dient, miteinander verbunden, wobei die Zwischenkreiskapazität auf dem Schaltungsträger (8) angeordnet ist;
   - bei den Halbleiterschaltelementen ($3_1$, $3_2$) handelt es sich um laterale Transistoren, bei denen alle Anschlussbereiche ($5_1$, $5_2$) einzig auf einer Seite des Halbleiterschaltelements ($3_1$, $3_2$) platziert sind.

2. Schaltzellenanordnung mit zumindest einer Schaltzelle nach Anspruch 1, **dadurch gekennzeichnet, dass** der erste und/oder zweite Anschlussbereich ($5_1$, $5_2$) des ersten oder zweiten Halbleiterschaltelements ($3_1$, $3_2$) aus einer elektrisch leitfähigen Anschlusskontaktfläche besteht, die sich über den gesamten jeweiligen Anschlussbereich ($5_1$, $5_2$) erstreckt und/oder dass ein erster oder zweiter Anschlussbereich ($5_1$, $5_2$) des ersten oder zweiten Halbleiterschaltelements ($3_1$, $3_2$) mehrere voneinander getrennte Anschlusskontakte ($5_{1a}$, $5_{1b}$ oder $5_{2a}$, $5_{2b}$) aufweist die dasselbe Potential haben.

3. Schaltzellenanordnung mit zumindest einer Schaltzelle nach Anspruch 2, **dadurch gekennzeichnet, dass** der zweite Teil ($7_2$) des Schaltungsträgers (8) mindestens 90% der Breite ($B_2$) des zweiten Anschlussbereichs ($5_2$) des ersten Halbleiterschaltelements ($3_1$) oder des ersten Anschlussbereichs ($5_1$) des zweiten Halbleiterschaltelements ($3_2$) aufweist oder dass die erste elektrische Leitung ($6_1$) und/oder die zweite elektrische Leitung ($6_2$) mindestens 90% der Breite ($B_1$) des ersten Anschlussbereichs ($5_1$) des ersten Halbleiterschaltelements ($3_1$) oder des zweiten Anschlussbereichs ($5_2$) des zweiten Halbleiterschaltelements ($3_2$) besitzt.

4. Schaltzellenanordnung mit zumindest einer Schaltzelle nach Anspruch 2 oder 3, **dadurch gekennzeichnet, dass** eine Anschlusskontaktfläche eine Größe von mehr als 30%, bevorzugt mehr als 40%, weiter bevorzugt mehr als 50%, weiter bevorzugt mehr als 60% aber weniger als 90% oder weniger als 80% der Grundfläche des ersten oder zweiten Halbleiterschaltelements ($3_1$, $3_2$) aufweist.

5. Schaltzellenanordnung mit zumindest einer Schaltzelle nach einem der vorherigen Ansprüche, **dadurch gekennzeichnet, dass** bei einer Draufsicht auf die erste Seite des Schaltungsträgers (8) die erste elektrische Leitung ($6_1$) über einen Bereich von mehr als 50% ihrer Länge, bevorzugt mehr als 60% ihrer Länge, weiter bevorzugt mehr als 70% ihrer Länge, weiter bevorzugt mehr als 80% ihrer Länge, weiter bevorzugt mehr als 90% ihrer Länge deckungsgleich zur zweiten elektrischen Leitung ($6_2$) verläuft.

6. Schaltzellenanordnung mit zumindest einer Schaltzelle nach Anspruch 5, **dadurch gekennzeichnet, dass** die erste elektrische Leitung ($6_1$) im Bereich des ersten Teils ($7_1$) des Schaltungsträgers (8) überwiegend auf der Seite des Schaltungsträgers (8) verläuft, auf der auch das erste Halbleiterschaltelement ($3_1$) angeordnet ist, und dass die zweite elektrische Leitung ($6_2$) im Bereich des ersten Teils ($7_1$) des Schaltungsträgers (8) überwiegend auf der Seite des Schaltungsträgers (8) verläuft, auf der auch das zweite Halbleiterschaltelement ($3_2$) angeordnet ist.

7. Schaltzellenanordnung mit zumindest einer Schaltzelle nach einem der vorherigen Ansprüche, **dadurch gekennzeichnet, dass** bei einer Draufsicht auf die erste Seite des Schaltungsträgers (8) das erste Halbleiterschaltelement ($3_1$) und das zweite Halbleiterschaltelement ($3_2$) deckungsgleich angeordnet sind oder dass sich bei einer Draufsicht auf die erste Seite des Schaltungsträgers (8) das erste Halbleiterschaltelement ($3_1$) und das zweite Halbleiterschaltelement ($3_2$) zu mehr als 20%, bevorzugt zu mehr als 30%, weiter bevorzugt zu mehr als 40%, weiter bevorzugt zu mehr als 50%, weiter bevorzugt zu mehr als 60%, weiter bevorzugt zu mehr als 70%, weiter bevorzugt zu mehr als 80%, weiter bevorzugt zu mehr als 90% aber zu weniger als 95% überlappen oder dass bei einer Draufsicht auf die erste Seite des Schaltungsträgers (8) das erste Halbleiterschaltelement ($3_1$) und das zweite Halbleiterschaltelement ($3_2$) vollständig versetzt zueinander angeordnet sind.

8. Schaltzellenanordnung mit zumindest einer Schaltzelle nach einem der vorherigen Ansprüche, **dadurch gekennzeichnet, dass** der erste Teil ($7_1$) und der zweite Teil ($7_2$) des Schaltungsträgers (8) einen Winkel von 180° zueinander bilden.

9. Schaltzellenanordnung mit zumindest einer Schaltzelle nach einem der vorherigen Ansprüche, **dadurch gekennzeichnet, dass** die erste elektrische Leitung ($6_1$) und die zweite elektrische Leitung ($6_2$) mittels Dickkupfertechnologie gebildet sind und/oder dass der zweite Teil ($7_2$) elektrisch leitfähige Oberflächen ($21_1$, $21_2$) aufweist, die mittels Dickkupfertechnologie gebildet sind, wobei diese mittels Durchkontaktierungen (22) galvanisch miteinander verbunden sind und/oder dass der zweite Teil ($7_2$) ein elektrisch leitfähiges Inlay (30) aufweist, das bevorzugt aus Kupfer gebildet ist.

10. Schaltzellenanordnung gemäß einem der vorherigen Ansprüche, **dadurch gekennzeichnet, dass** es sich bei dem ersten Anschlussbereich ($5_1$) um einen Source-Anschluss handelt und dass es sich bei dem zweiten Anschlussbereich ($5_2$) um einen Drain-Anschluss handelt und/oder dass das Halbleiterschaltelement ($3_1$, $3_2$) ungehäust direkt mit dem Schaltungsträger (8) elektrisch leitend verbunden ist und/oder

dass das erste Halbleiterschaltelement ($3_1$) und das zweite Halbleiterschaltelement ($3_2$) bezüglich ihres ersten und zweiten Anschlussbereichs ($5_1$, $5_2$) spiegelsymmetrisch aufgebaut sind.

11. Schaltzellenanordnung mit zumindest zwei Schaltzellen die gemäß einem der vorherigen Ansprüche gebildet sind, **dadurch gekennzeichnet, dass** die zumindest beiden Schaltzellen (2, 2a, 2b, $2_1$, $2_2$, $2_3$) parallel zueinander geschaltet sind und einen Schaltzellenparallelblock (50) bilden und auf einem gemeinsamen Schaltungsträger (8) ausgebildet sind und dass die jeweils ersten elektrischen Leitungen ($6_1$) und die jeweils zweiten elektrischen Leitungen ($6_2$) der zumindest beiden Schaltzellen (2, 2a, 2b, $2_1$, $2_2$, $2_3$) galvanisch miteinander verbunden sind und dass die zumindest beiden elektrisch leitfähigen zweiten Teile ($7_2$) galvanisch miteinander verbunden sind.

12. Schaltzellenanordnung mit zwei Schaltzellen oder mit zwei Schaltzellenparallelblöcken die gemäß einem der Ansprüche 1 bis 10 oder gemäß Anspruch 11 gebildet sind, **dadurch gekennzeichnet, dass** die jeweils ersten elektrischen Leitungen ($6_1$) jeder Schaltzelle (2, $2_1$, $2_2$) oder jedes Schaltzellenparallelblocks (50) galvanisch miteinander verbunden sind, und dass die jeweils zweiten elektrischen Leitungen ($6_2$) jeder Schaltzelle (2, $2_1$, $2_2$) oder jedes Schaltzellenparallelblocks (50) galvanisch miteinander verbunden sind, und dass der zweite Teil ($7_2$) der ersten Schaltzelle ($2_1$) oder des ersten Schaltzellenparallelblocks (50) mit einem ersten Anschluss einer elektrischen Maschine verbindbar ist oder verbunden ist und dass der zweite Teil ($7_2$) der zweiten Schaltzelle ($2_2$) oder des zweiten Schaltzellenparallelblocks (50) mit einem zweiten Anschluss der elektrischen Maschine verbindbar ist oder verbunden ist, sodass die zwei Schaltzellen (2, $2_1$, $2_2$) oder die zwei Schaltzellenparallelblöcke (50) als Vollbrücke betreibbar sind.

13. Schaltzellenanordnung mit zwei Schaltzellen oder mit zwei Schaltzellenparallelblöcken gemäß Anspruch 12, **dadurch gekennzeichnet, dass** die zwei Schaltzellen (2, $2_1$, $2_2$) oder die zwei Schaltzellenparallelblöcke (50) auf einem gemeinsamen Schaltungsträger (8) ausgebildet sind, oder dass die zwei Schaltzellen (2, $2_1$, $2_2$) oder die zwei Schaltzellenparallelblöcke (50) auf verschiedenen Schaltungsträgern (8) ausgebildet und mittels Abstandshalter übereinander angeordnet sind.

14. Schaltzellenanordnung mit n-Schaltzellen oder mit n-Schaltzellenparallelblöcken die gemäß einem der Ansprüche 1 bis 10 oder gemäß Anspruch 11 gebildet sind mit n > 2 und $n \in \mathbb{N}$ **dadurch gekennzeichnet, dass** die jeweils ersten elektrischen Leitungen ($6_1$) jeder der n-Schaltzellen (2, $2_1$, $2_2$, $2_3$, $2_n$) oder jeder der n-Schaltzellenparallelblöcke (50) miteinander verbunden sind, und dass die jeweils zweiten elektrischen Leitungen (62) jeder der n-Schaltzellen (2, $2_1$, $2_2$, $2_3$, $2_n$) oder jeder der n-Schaltzellenparallelblöcke (50) miteinander verbunden sind, und dass der zweite Teil ($7_2$) jeder der n-Schaltzellen (2, $2_1$, $2_2$, $2_3$, $2_n$) oder jeder der n-Schaltzellenparallelblöcke (50) mit einem der n-Anschlüsse einer elektrischen Maschine verbindbar ist oder verbunden ist.

15. Schaltzellenanordnung mit n-Schaltzellen oder mit n-Schaltzellenparallelblöcken gemäß Anspruch 14, **dadurch gekennzeichnet, dass** die n-Schaltzellen (2, $2_1$, $2_2$, $2_3$, $2_n$) oder die n-Schaltzellenparallelblöcke (50) auf einem gemeinsamen Schaltungsträger (8) ausgebildet sind und dass die Gleichspannungsversorgung (4) in Form einer Leitung den Schaltungsträger (8) in zwei Bereiche teilt und dass alle geraden n-Schaltzellen (2, $2_2$, $2_n$) oder n Schaltzellenparallelblöcke (50) voneinander beabstandet in dem ersten Bereich angeordnet und orthogonal zu der Gleichspannungsversorgungsleitung ausgebildet und mit dieser verbunden sind, wohingegen alle ungeraden n-Schaltzellen (2, $2_1$, $2_3$, $2_n$) oder n-Schaltzellenparallelblöcke (50) voneinander beabstandet in dem zweiten Bereich angeordnet und orthogonal zu der Gleichspannungsversorgungsleitung ausgebildet und mit dieser verbunden sind, oder

dass die n-Schaltzellen (2, $2_1$, $2_2$, $2_3$, $2_n$) oder die n-Schaltzellenparallelblöcke (50) mittels Abstandshalter übereinander angeordnet sind.

16. Schaltzellenanordnung mit n-Schaltzellen oder mit n-Schaltzellenparallelblöcken gemäß Anspruch 14, **dadurch gekennzeichnet, dass** die n-Schaltzellen (2, $2_1$, $2_2$, $2_3$, $2_n$) oder die n-Schaltzellenparallelblöcke (50) zu ihrer benachbarten n-Schaltzelle (2, $2_1$, $2_2$, $2_3$, $2_n$) oder zu seinem benachbarten n-Schaltzellenparallelblock (50) einen Winkel von $\gamma = \frac{360°}{n}$ bildet, wobei die ersten und zweiten elektrischen Leitungen ($6_1$, $6_2$) jeder der n-Schaltzellen (2, $2_1$, $2_2$, $2_3$, $2_n$) oder der n-Schaltzellenparallelblöcke (50) näher an einem gemeinsamen Zentrum liegen als der zweite Anschlussbereich ($5_2$) des ersten Halbleiterschaltelements ($3_1$) oder der erste Anschlussbereich ($5_1$) des zweiten Halbleiterschaltelements ($3_2$) jedes der n-Schaltzellen (2, $2_1$, $2_2$, $2_3$, $2_n$) oder der n-Schaltzellenparallelblöcke (50).

17. Schaltzellenanordnung mit n-Schaltzellen oder mit n-Schaltzellenparallelblöcken gemäß Anspruch 14 oder 16, **dadurch gekennzeichnet, dass** der erste Anschluss ($4_1$) der Gleichspannungsversorgung (4) im Zentrum auf der ersten Seite des Schaltungsträgers (8) angeordnet ist und dass der zweite Anschluss ($4_2$) der Gleichspannungsversorgung (4) im Zentrum auf der zweiten Seite des Schaltungsträgers (8) angeordnet ist und dass die n-Schaltzellen (2, $2_1$, $2_2$, $2_3$, $2_n$) oder die n-Schaltzellenparallelblöcke (50) derart auf dem Schaltungsträger (8) angeordnet sind, dass sie sich vom Zentrum radial nach außen erstrecken, wobei jede der n-Schaltzellen (2, $2_1$, $2_2$, $2_3$, $2_n$) oder jeder der n-Schaltzellenparallelblöcke (50) zu ihrer benachbarten n-Schaltzelle (2, $2_1$, $2_2$, $2_3$, $2_n$) oder zu seinem benachbarten n-Schaltzellenparallelblock (50) einen Winkel von

$$\gamma = \frac{360°}{n}$$ bildet.

18. Schaltzellenanordnung mit n-Schaltzellen oder mit n-Schaltzellenparallelblöcken gemäß Anspruch 14, 16 oder 17, **dadurch gekennzeichnet, dass** der zweite Anschluss ($4_2$) der Gleichspannungsversorgung (4) im Zentrum des Schaltungsträgers (8) angeordnet ist, und dass der erste Anschluss ($4_1$) als umlaufende ringförmige Fläche ausgeführt ist, wobei innerhalb des als umlaufende ringförmige Fläche ausgebildeten ersten Anschluss ($4_1$) getrennt von diesem der zweite Anschluss ($4_2$) der Gleichspannungsversorgung (4) angeordnet ist, und dass die n-Schaltzellen (2, $2_1$, $2_2$, $2_3$, $2_n$) oder die n-Schaltzellenparallelblöcke (50) derart auf dem Schaltungsträger (8) angeordnet sind, dass sie sich vom Zentrum radial nach außen erstrecken, wobei jede der n-Schaltzellen (2, $2_1$, $2_2$, $2_3$, $2_n$) oder jeder der n-Schaltzellenparallelblöcke (50) zu ihrer benachbarten n-Schaltzelle (2, $2_1$, $2_2$, $2_3$, $2_n$) oder zu seinem benachbarten n-Schaltzellenparallelblock (50) einen Winkel von $\gamma = \frac{360°}{n}$ bildet.

19. Umrichter aufweisend zwei Schaltzellenanordnungen gemäß einem der Ansprüche 12 bis 17, **dadurch gekennzeichnet, dass** beide Schaltzellenanordnungen (1) so angeordnet und/oder ausgebildet sind dass eine erste Schaltzellenanordnung (1) eine Wechselspannung gleichrichtet, und dass eine zweite Schaltzellenanordnung (1) eine von der ersten Schaltzellenanordnung (1) bezogene Gleichspannung wechselrichtet, und dass die zweite Schaltzellenanordnung (1) eine Wechselspannung gleichrichtet, und dass die erste Schaltzellenanordnung (1) eine von der zweiten Schaltzellenanordnung (1) bezogene Gleichspannung wechselrichtet, sodass ein Energiefluss in beide Richtungen ermöglicht ist.

**Claims**

1. Switch cell arrangement (1) comprising at least one switch cell (2, $2_1$, $2_2$, $2_3$), the at least one switch cell (2, $2_1$, $2_2$, $2_3$) comprising the following features:

   - a circuit carrier (8);
   - at least two semiconductor switch elements ($3_1$, $3_2$), a first semiconductor switch element ($3_1$) being arranged on a first side of the circuit carrier (8) and being connected thereto so as to conduct electricity, and a second semiconductor switch element ($3_2$) being arranged on a second side of the circuit carrier (8) that is opposite the first side and being connected thereto so as to conduct electricity;
   - a first terminal region ($5_1$) of the first semiconductor switch element ($3_1$) is connected to a first terminal ($4_1$) of a DC voltage supply (4) by means of a first electrical line ($6_1$) in a first part ($7_1$) of the circuit carrier (8);
   - a second terminal region ($5_2$) of the second semiconductor switch element ($3_2$) is connected to a second terminal ($4_2$) of the DC voltage supply (4) by means of a second electrical line ($6_2$) in the first part ($7_1$) of the circuit carrier (8);
   - a second terminal region ($5_2$) of the first semiconductor switch element ($3_1$) and a first terminal region ($5_1$) of the second semiconductor switch element ($3_2$) are connected to one another and to an electrically conductive second part ($7_2$) of the circuit carrier (8);

   **characterised by** the following features:

   - the first electrical line ($6_1$) and the second electrical line ($6_2$) are interconnected by means of at least one intermediate circuit capacitor (4) which is used to supply the DC voltage, the intermediate circuit capacitor being arranged on the circuit carrier (8);
   - the semiconductor switch elements ($3_1$, $3_2$) are lateral transistors in which all terminal regions ($5_1$, $5_2$) are placed only on one side of the semiconductor switch element ($3_1$, $3_2$).

2. Switch cell arrangement comprising at least one switch cell according to claim 1, **characterised in that**
   the first and/or second terminal region ($5_1$, $5_2$) of the first or second semiconductor switch element ($3_1$, $3_2$) consists of an electrically conductive terminal contact surface which extends over the entire relevant terminal region ($5_1$, $5_2$) and/or **in that** a first or second terminal region ($5_1$, $5_2$) of the first or second semiconductor switch element ($3_1$, $3_2$) has a plurality of separate terminal contacts ($5_{1a}$, $5_{1b}$ or $5_{2a}$, $5_{2b}$) which have the same potential.

3. Switch cell arrangement comprising at least one switch cell according to claim 2, **characterised in that**
   the second part ($7_2$) of the circuit carrier (8) is at least 90% of the width ($B_2$) of the second terminal region ($5_2$) of the first semiconductor switch element ($3_1$) or of the first terminal region ($5_1$) of the second semiconductor switch element ($3_2$) or **in that** the first electrical line ($6_1$) and/or the second electrical line ($6_2$) is at least 90% of the width ($B_1$) of the first terminal region ($5_1$) of the first semiconductor switch element ($3_1$) or of the second terminal region ($5_2$) of the second semiconductor switch element ($3_2$).

4. Switch cell arrangement comprising at least one switch cell according to either claim 2 or claim 3, **characterised in that**
   a terminal contact surface has a size of more than 30%, preferably more than 40%, more preferably more than 50%, more preferably more than 60%, but less than 90% or less than 80% of the surface area of the first or second semiconductor switch element ($3_1$, $3_2$).

5. Switch cell arrangement comprising at least one switch cell according to any of the preceding claims, **characterised in that**
   in a plan view of the first side of the circuit carrier (8), the first electrical line ($6_1$) extends over a region of more than 50% of its length, preferably more than 60% of its length, more preferably more than 70% of its length, more preferably more than 80% of its length, more preferably more than 90% of its length, congruently to the second electrical line ($6_2$).

6. Switch cell arrangement comprising at least one switch cell according to claim 5, **characterised in that**
   the first electrical line ($6_1$) in the region of the first part ($7_1$) of the circuit carrier (8) extends predominantly on the side of the circuit carrier (8) on which the first semiconductor switch element ($3_1$) is also arranged, and **in that** the second electrical line ($6_2$) in the region of the first part ($7_1$) of the circuit carrier (8) extends predominantly on the side of the circuit carrier (8) on which the second semiconductor switch element ($3_2$) is also arranged.

7. Switch cell arrangement comprising at least one switch cell according to any of the preceding claims, **characterised in that**
   in a plan view of the first side of the circuit carrier (8), the first semiconductor switch element ($3_1$) and the second semiconductor switch element ($3_2$) are arranged congruently or **in that**, in a plan view of the first side of the circuit carrier (8), the first semiconductor switch element ($3_1$) and the second semiconductor switch element ($3_2$) overlap by more than 20%, preferably by more than 30%, more preferably by more than 40%, more preferably by more than 50%, more preferably by more than 60%, more preferably by more than 70%, more preferably by more than 80%, more preferably by more than 90%, but by less than 95% or **in that**, in a plan view of the first side of the circuit carrier (8), the first semiconductor switch element ($3_1$) and the second semiconductor switch element ($3_2$) are arranged so as to be completely offset from one another.

8. Switch cell arrangement comprising at least one switch cell according to any of the preceding claims, **characterised in that**
the first part ($7_1$) and the second part ($7_2$) of the circuit carrier (8) form an angle of 180° with respect to one another.

9. Switch cell arrangement comprising at least one switch cell according to any of the preceding claims, **characterised in that**
the first electrical line ($6_1$) and the second electrical line ($6_2$) are formed by means of thick-copper technology and/or **in that** the second part ($7_2$) has electrically conductive surfaces ($21_1$, $21_2$) which are formed by means of thick-copper technology, these being galvanically interconnected by means of feedthroughs (22), and/or **in that** the second part ($7_2$) has an electrically conductive inlay (30) which is preferably formed of copper.

10. Switch cell arrangement according to any of the preceding claims, **characterised in that**
the first terminal region ($5_1$) is a source terminal and **in that** the second terminal region ($5_2$) is a drain terminal and/or **in that** the semiconductor switch element ($3_1$, $3_2$) is connected directly to the circuit carrier (8) in an unhoused manner so as to conduct electricity and/or **in that** the first semiconductor switch element ($3_1$) and the second semiconductor switch element ($3_2$) are constructed so as to be mirror-symmetrical with respect to the first and second terminal region thereof ($5_1$, $5_2$).

11. Switch cell arrangement comprising at least two switch cells which are formed according to any of the preceding claims, **characterised in that** the at least two switch cells (2, 2a, 2b, $2_1$, $2_2$, $2_3$) are connected in parallel with one another, form a switch cell parallel block (50) and are formed on a common circuit carrier (8) and **in that** the respective first electrical lines ($6_1$) and the respective second electrical lines ($6_2$) of the at least two switch cells (2, 2a, 2b, $2_1$, $2_2$, $2_3$) are galvanically interconnected and **in that** the at least two electrically conductive second parts ($7_2$) are galvanically interconnected.

12. Switch cell arrangement comprising two switch cells or comprising two switch cell parallel blocks formed according to any of claims 1 to 10 or according to claim 11, **characterised in that** the respective first electrical lines ($6_1$) of each switch cell (2, $2_1$, $2_2$) or each switch cell parallel block (50) are galvanically interconnected, and **in that** the respective second electrical lines ($6_2$) of each switch cell (2, $2_1$, $2_2$) or each switch cell parallel block (50) are galvanically interconnected, and **in that** the second part ($7_2$) of the first switch cell ($2_1$) or the first switch cell parallel block (50) is or can be connected to a first terminal of an electric machine and **in that** the second part ($7_2$) of the second switch cell ($2_2$) or the second switch cell parallel block (50) is or can be connected to a second terminal of the electric machine such that the two switch cells (2, $2_1$, $2_2$) or the two switch cell parallel blocks (50) can be operated as a full bridge.

13. Switch cell arrangement comprising two switch cells or comprising two switch cell parallel blocks according to claim 12, **characterised in that**
the two switch cells (2, $2_1$, $2_2$) or the two switch cell parallel blocks (50) are formed on a common circuit carrier (8), or **in that** the two switch cells (2, $2_1$, $2_2$) or the two switch cell parallel blocks (50) are formed on different circuit carriers (8) and are arranged one above the other by means of spacers.

14. Switch cell arrangement comprising n switch cells or comprising n switch cell parallel blocks formed according to any of claims 1 to 10 or according to claim 11, where n > 2 and n $\varepsilon$ N, **characterised in that** the respective first electrical lines (61) of each of the n switch cells (2, $2_1$, $2_2$, $2_3$, $2_n$) or each of the n switch cell parallel blocks (50) are interconnected, and **in that** the respective second electrical lines ($6_2$) of each of the n switch cells (2, $2_1$, $2_2$, $2_3$, $2_n$) or each of the n switch cell parallel blocks (50) are interconnected, and **in that** the second part ($7_2$) of each of the n switch cells (2, $2_1$, $2_2$, $2_3$, $2_n$) or each of the n switch cell parallel blocks (50) is or can be connected to one of the n terminals of an electric machine.

15. Switch cell arrangement comprising n switch cells or comprising n switch cell parallel blocks according to claim 14, **characterised in that**
the n switch cells (2, $2_1$, $2_2$, $2_3$, $2_n$) or the n switch cell parallel blocks (50) are formed on a common circuit carrier (8) and **in that** the DC voltage supply (4) in the form of a line divides the circuit carrier (8) into two regions and **in that** all of the even n switch cells (2, 22, 2n) or n switch cell parallel blocks (50) are arranged so as to be spaced apart in the first region and formed orthogonally with respect to the DC voltage supply line and connected thereto, whereas all odd n switch cells (2, 21, 23, 2n) or n switch cell parallel blocks (50) are arranged so as to be spaced apart in the second region and formed orthogonally with respect to the DC voltage supply line and connected thereto, or **in that** the n switch cells (2, 21, 22, 23, 2n) or the n switch cell parallel blocks (50) are arranged one above the other by means of spacers.

16. Switch cell arrangement comprising n switch cells or comprising n switch cell parallel blocks according to claim 14, **characterised in that**
the n switch cells $(2, 2_1, 2_2, 2_3, 2_n)$ or the n switch cell parallel blocks (50) form an angle of $\gamma = \dfrac{360°}{n}$ with respect to their adjacent n switch cells $(2, 2_1, 2_2, 2_3, 2_n)$ or with respect to its adjacent n switch cell parallel block (50), the first and second electrical lines $(6_1, 6_2)$ of each of the n switch cells $(2, 2_1, 2_2, 2_3, 2_n)$ or n switch cell parallel blocks (50) being closer to a common centre than the second terminal region $(5_2)$ of the first semiconductor switch element $(3_1)$ or the first terminal region $(5_1)$ of the second semiconductor switch element $(3_2)$ of each of the n switch cells $(2, 2_1, 2_2, 2_3, 2_n)$ or the n switch cell parallel blocks (50).

17. Switch cell arrangement comprising n switch cells or comprising n switch cell parallel blocks according to either claim 14 or claim 16, **characterised in that**
the first terminal $(4_1)$ of the DC voltage supply (4) is arranged in the centre on the first side of the circuit carrier (8) and **in that** the second terminal $(4_2)$ of the DC voltage supply (4) is arranged in the centre on the second side of the circuit carrier (8) and **in that** the n switch cells $(2, 2_1, 2_2, 2_3, 2_n)$ or the n switch cell parallel blocks (50) are arranged on the circuit carrier (8) such that they extend radially outwards from the centre, each of the n switch cells $(2, 2_1, 2_2, 2_3, 2_n)$ or each of the n switch cell parallel blocks (50) forming an angle of $\gamma = \dfrac{360°}{n}$ with respect to its adjacent n switch cell $(2, 2_1, 2_2, 2_3, 2_n)$ or with respect to its adjacent n switch cell parallel block (50).

18. Switch cell arrangement comprising n switch cells or comprising n switch cell parallel blocks according to either claim 14, claim 16 or claim 17, **characterised in that**
the second terminal $(4_2)$ of the DC voltage supply (4) is arranged in the centre of the circuit carrier (8), and **in that** the first terminal $(4_1)$ is designed as a circumferential annular surface, the second terminal $(4_2)$ of the DC voltage supply (4) being arranged inside the first terminal $(4_1)$ formed as a circumferential annular surface so as to be separate therefrom, and **in that** the n switch cells $(2, 2_1, 2_2, 2_3, 2_n)$ or the n switch cell parallel blocks (50) are arranged on the circuit carrier (8) such that they extend radially outwards from the centre, each of the n switch cells $(2, 2_1, 2_2, 2_3, 2_n)$ or each of the n switch cell parallel blocks (50) forming an angle of $\gamma = \dfrac{360°}{n}$ with respect to its adjacent n switch cell $(2, 2_1, 2_2, 2_3, 2_n)$ or to its adjacent n switch cell parallel block (50).

19. Converter comprising two switch cell arrangements according to any of claims 12 to 17, **characterised in that**
the two switch cell arrangements (1) are arranged and/or designed such that a first switch cell arrangement (1) rectifies an AC voltage, and that a second switch cell arrangement (1) inverts a DC voltage obtained from the first switch cell arrangement (1), and that the second switch cell arrangement (1) rectifies an AC voltage, and that the first switch cell arrangement (1) inverts a DC voltage obtained from the second switch cell arrangement (1), such that energy flow in both directions is made possible.

## Revendications

1. Agencement de cellules de commutation (1) comprenant au moins une cellule de commutation $(2, 2_1, 2_2, 2_3)$, dans lequel ladite au moins une cellule de commutation $(2, 2_1, 2_2, 2_3)$ inclut les éléments suivants :

   - un support de circuit (8) ;
   - au moins deux éléments de commutation à semi-conducteur $(3_1, 3_2)$, dans lesquels un premier élément de commutation à semi-conducteur $(3_1)$ est agencé sur un premier côté du support de circuit (8) et est relié à celui-ci de manière à conduire l'électricité, et dans lesquels un second élément de commutation à semi-conducteur $(3_2)$ est agencé sur un second côté, à l'opposé du premier côté, de support de circuit (8) et est relié à celui-ci de manière à conduire l'électricité ;
   - une première zone de connexion $(5_1)$ du premier élément de commutation à semi-conducteur $(3_1)$ est reliée, via une première ligne électrique $(6_1)$ dans une première partie $(7_1)$ du support de circuit (8), à une première connexion $(4_1)$ d'une alimentation à tension continue (4) ;
   - une seconde zone de connexion $(5_2)$ du second élément de commutation à semi-conducteur $(3_2)$ est reliée, via une seconde ligne électrique $(6_2)$ dans la première partie $(7_1)$ du sup-

port de circuit (8), à une seconde connexion ($4_2$) de l'alimentation à tension continue (4) ;
- une deuxième zone de connexion ($5_2$) du premier élément de commutation à semi-conducteur ($3_1$) et une première zone de commutation ($5_1$) du second élément de commutation à semi-conducteur ($3_2$) sont reliées l'une à l'autre et à une seconde partie ($7_2$), capable de conduire l'électricité, du support de circuit (8) ;

**caractérisé par** les caractéristiques suivantes :

- la première ligne électrique ($6_1$) et la seconde ligne électrique ($6_2$) sont reliées l'une à l'autre via au moins un condensateur de circuit intermédiaire (4), qui sert à l'alimentation à tension continue, ledit condensateur de circuit intermédiaire étant agencé sur le support de circuit (8) ;
- dans lequel les éléments de commutation à semi-conducteur ($3_1$, $3_2$) sont des transistors latéraux dans lesquels toutes les zones de connexion ($5_1$, $5_2$) sont placées uniquement sur un côté de l'élément de commutation à semi-conducteur ($3_1$, $3_2$).

2. Agencement de cellules de commutation comprenant au moins une cellule de commutation selon la revendication 1, **caractérisé en ce que** la première et/ou la seconde zone de connexion ($5_1$, $5_2$) du premier ou du second élément de commutation à semi-conducteur ($3_1$, $3_2$) est constituée d'une surface de contact de connexion conductrice de l'électricité qui s'étend sur la totalité de la zone de connexion respective ($5_1$, $5_2$), et/ou **en ce qu'**une première ou une seconde zone de connexion ($5_1$, $5_2$) du premier ou du second élément de commutation à semi-conducteur ($3_1$, $3_2$) comporte plusieurs contacts de connexion ($5_{1a}$, $5_{1b}$ ou $5_{2a}$, $5_{2b}$) séparés les uns des autres, qui ont le même potentiel.

3. Agencement de cellules de commutation comprenant au moins une cellule de commutation selon la revendication 2, **caractérisé en ce que** la seconde partie ($7_2$) du support de circuit (8) présente au moins 90 % de la largeur (B2) de la seconde zone de connexion ($5_2$) du premier élément de commutation à semi-conducteur ($3_1$) ou de la première zone de connexion ($5_1$) du second élément de commutation à semi-conducteur ($3_2$), ou **en ce que** la première ligne électrique ($6_1$) et/ou la seconde ligne électrique ($6_2$) possède au moins 90 % de la largeur (B1) de la première zone de connexion ($5_1$) du premier élément de commutation à semi-conducteur ($3_1$) ou de la seconde zone de connexion ($5_2$) du second élément de commutation à semi-conducteur ($3_2$).

4. Agencement de cellules de commutation comprenant au moins une cellule de commutation selon la revendication 2 ou 3, **caractérisé en ce qu'**une surface de contact de connexion présente une taille de plus de 30 %, de préférence plus de 40 %, de manière encore préférée plus de 50 %, ou encore plus de 70 % mais moins de 90 % ou moins de 80 % de la surface de base du premier ou du second élément de commutation à semi-conducteur ($3_1$, $3_2$).

5. Agencement de cellules de commutation comprenant au moins une cellule de commutation selon l'une des revendications précédentes, **caractérisé en ce que**, dans une vue de dessus sur le premier côté du support de circuit (8) la première ligne électrique ($6_1$) s'étend, sur une plage de plus de 50 % de sa longueur, de préférence plus de 60 % de sa longueur, de manière encore préférée plus de 70 % de sa longueur, ou encore plus de 80 % de sa longueur, et de manière encore plus préférée plus de 90 % de sa longueur de manière à coïncider à la seconde ligne électrique ($6_2$).

6. Agencement de cellules de commutation comprenant au moins une cellule de commutation selon la revendication 5, **caractérisé en ce que** la première ligne électrique ($6_1$) s'étend, dans la région de la première partie ($7_1$) du support de circuit (8), en majeure partie sur le côté du support de circuit (8) sur lequel est également agencé le premier élément de commutation à semi-conducteur ($3_1$), et **en ce que** la seconde ligne électrique ($6_2$) s'étend, dans la région de la première partie ($7_1$) du support de circuit (8), en majeure partie sur le côté du support de circuit (8) sur lequel est également agencé le second élément de commutation à semi-conducteur ($3_2$).

7. Agencement de cellules de commutation comprenant au moins une cellule de commutation selon l'une des revendications précédentes, **caractérisé en ce que**, dans une vue de dessus sur le premier côté du support de circuit (8), le premier élément de commutation à semi-conducteur ($3_1$) et le second élément de commutation à semi-conducteur ($3_2$) sont agencés de manière à coïncider, ou **en ce que**, dans une vue de dessus sur le premier côté du support de circuit (8), le premier élément de commutation à semi-conducteur ($3_1$) et le second élément de commutation à semi-conducteur ($3_2$) se chevauchent sur plus de 20 %, de préférence plus de 30 %, encore de préférence plus de 40 %, ou encore plus de 50 %, de manière encore plus préférée plus de 70 %, ou encore plus de 70 %, de manière encore plus préférée plus de 80 %, ou encore plus de 90 %, mais sur moins de 95 %, ou **en ce que**, dans une vue de dessus sur le premier côté du support de circuit (8), le premier élément de commutation à semi-conducteur ($3_1$) et le second élément de commutation à semi-conducteur ($3_2$) sont agencés de manière totalement décalée l'un par rapport à l'autre.

8. Agencement de cellules de commutation comprenant au moins une cellule de commutation selon l'une des revendications précédentes, **caractérisé en ce que** la première partie $(7_1)$ et la seconde partie $(7_2)$ du support de circuit (8) forment un angle de 180° l'une par rapport à l'autre.

9. Agencement de cellules de commutation comprenant au moins une cellule de commutation selon l'une des revendications précédentes, **caractérisé en ce que** la première ligne électrique $(6_1)$ et la seconde ligne électrique $(6_2)$ sont formées au moyen d'une technologie en cuivre épais et/ou **en ce que** la seconde partie $(7_2)$ présente des surfaces capables de conduire l'électricité $(2_{11}, 2_{12})$ qui sont formées au moyen de la technologie en cuivre épais, dans lequel ces surfaces sont reliées l'une à l'autre sur le plan galvanique au moyen de vias conducteurs $(2_2)$ et/ou **en ce que** la seconde partie $(7_2)$ comprend un insert capable de conduire l'électricité $(3_0)$, qui est réalisé de préférence en cuivre.

10. Agencement de cellules de commutation selon l'une des revendications précédentes, **caractérisé en ce que** la première zone de connexion $(5_1)$ est une connexion de source et **en ce que** la seconde zone connexion $(5_2)$ est une connexion de drain et/ou **en ce que** l'élément de commutation à semi-conducteur $(3_1, 3_2)$ est relié directement sans enrobage au support de circuit (8) de manière à conduire l'électricité et/ou

 **en ce que** le premier élément de commutation à semi-conducteur $(3_1)$ et le second élément de commutation à semi-conducteur $(3_2)$ sont constitués de manière symétrique pour ce qui concerne leur première et leur seconde zone de connexion $(5_1, 5_2)$.

11. Agencement de cellules de commutation comprenant au moins deux cellules de commutation qui sont formées conformément à l'une des revendications précédentes, **caractérisé en ce que** lesdites au moins deux cellules de commutation $(2, 2a, 2b, 2_1, 2_2, 2_3)$ sont branchées parallèlement l'une à l'autre et forment un bloc parallèle de cellules de commutation (50) et sont réalisées sur un support de circuit commun (8), et **en ce que** les premières lignes électriques respectives $(6_1)$ et les secondes lignes électriques respectives $(6_2)$ desdites au moins deux cellules de commutation $(2, 2a, 2b, 2_1, 2_2, 2_3)$ sont reliées sur le plan galvanique les unes aux autres, et **en ce que** lesdites au moins deux secondes parties $(7_2)$ capables de conduire l'électricité sont reliées sur le plan galvanique les unes aux autres.

12. Agencement de cellules de commutation comprenant deux cellules de commutation ou deux blocs parallèles de cellules de commutation qui sont formé(e)s conformément à l'une des revendications 1 à 10 ou conformément à la revendication 11, **caractérisé en ce que** les premières lignes électriques respectives $(6_1)$ de chaque cellule de commutation $(2, 2_1, 2_2)$ ou de chaque bloc parallèle de cellules de commutation (50) sont reliées les unes aux autres sur le plan galvanique, et **en ce que** les secondes lignes électriques respectives $(6_2)$ de chaque cellule de commutation $(2, 2_1, 2_2)$ ou de chaque bloc parallèle de cellules de commutation (50) sont reliées les unes aux autres sur le plan galvanique, et **en ce que** la seconde partie $(7_2)$ de la première cellule de commutation $(2_1)$ ou du premier bloc parallèle de cellules de commutation (50) est reliée ou susceptible d'être reliée à une première connexion d'une machine électrique, et **en ce que** la seconde partie $(7_2)$ de la seconde cellule de commutation $(2_2)$ ou du second bloc parallèle de cellules de commutation (50) est reliée ou susceptible d'être reliée à une seconde connexion de la machine électrique, de sorte que les deux cellules de commutation $(2, 2_1, 2_2)$ ou les deux blocs parallèles de cellules de commutation (50) peuvent être amenées à fonctionner à la manière d'un pont complet.

13. Agencement de cellules de commutation comprenant deux cellules de commutation ou deux blocs parallèles de cellules de commutation selon la revendication 12, **caractérisé en ce que** les deux cellules de commutation $(2, 2_1, 2_2)$ ou les deux blocs parallèles de cellules de commutation (50) sont réalisé(e)s sur un support de circuit commun (8), ou **en ce que** les deux cellules de commutation $(2, 2_1, 2_2)$ ou les deux blocs parallèles de cellules de commutation (50) sont réalisé(e)s sur des supports de circuit différents (8) et sont agencé(e)s les uns/les unes au-dessus des autres au moyen d'éléments d'écartement.

14. Agencement de cellules de commutation comprenant n cellules de commutation ou n blocs parallèles de cellules de commutation qui sont réalisé(e)s conformément à l'une des revendications 1 à 10 ou conformément à la revendication 11, avec n > 2 et n $\in$ N, **caractérisé en ce que** les premières lignes électriques respectives $(6_1)$ de chacune des n cellules de commutation $(2, 2_1, 2_2, 2_3, 2n)$ ou de chacun des n blocs parallèles de cellules de commutation (50) sont reliées les unes aux autres, et **en ce que** les secondes lignes électriques respectives $(6_2)$ de chacune des n cellules de commutation $(2, 2_1, 2_2, 2_3, 2n)$ ou de chacun des n blocs parallèles de cellules de commutation (50) sont reliées les unes aux autres, et **en ce que** la seconde partie (72) de chacune des n cellules de commutation $(2, 2_1, 2_2, 2_3, 2n)$ ou de chacun des n blocs parallèles de cellules de commutation (50) est reliée ou susceptible d'être reliée à l'une des n connexions d'une machine électrique.

**15.** Agencement de cellules de commutation comprenant n cellules de commutation ou n blocs parallèles de cellules de commutation selon la revendication 14, **caractérisé en ce que** les n cellules de commutation (2, $2_1$, $2_2$, $2_3$, 2n) ou les n blocs parallèles de cellules de commutation (50) sont réalisé(e)s sur un support de circuit commun (8) et **en ce que** l'alimentation à tension continue (4) sous la forme d'une ligne partage le support de circuit (8) en deux zones, et **en ce que** toutes les n cellules de commutation paires (2, $2_2$, 2n) ou tous les n blocs parallèles de cellules de commutation pairs (50) sont agencé(e)s en écartement les uns/les unes des autres dans la première zone et sont réalisé(e)s perpendiculaires à la ligne d'alimentation à tension continue et sont relié(e)s à celle-ci, tandis que par contre toutes les n cellules de commutation impaires (2, $2_1$, $2_3$, 2n) ou tous les n blocs parallèles de cellules de commutation impairs (50) sont agencé(e)s en écartement les uns/les unes des autres dans la seconde zone et sont réalisé(e)s perpendiculaires à la ligne d'alimentation à tension continue et sont relié(e)s à celle-ci, ou
  **en ce que** les n cellules de commutation (2, $2_1$, $2_2$, $2_3$, 2n) ou les n blocs parallèles de cellules de commutation (50) sont agencé(e)s les uns/les unes au-dessus des autres au moyen d'éléments d'écartement.

**16.** Agencement de cellules de commutation comprenant n cellules de commutation ou n blocs parallèles de cellules de commutation selon la revendication 14, **caractérisé en ce que** chacune des n cellules de commutation (2, $2_1$, $2_2$, $2_3$, 2n) ou chacun des n blocs parallèles de cellules de commutation (50) forme par rapport à sa cellule de commutation voisine (2, $2_1$, $2_2$, $2_3$, 2n) ou à son bloc parallèle de cellules de commutation voisin (50) un angle de $\gamma = 360°/n$, et dans lequel les premières et les secondes lignes électriques ($6_1$, $6_2$) de chacune des n cellules de commutation (2, $2_1$, $2_2$, $2_3$, 2n) ou de chacun des n blocs parallèles de cellules commutation (50) sont situées plus proches d'un centre commun que la seconde zone de connexion ($5_2$) du premier élément de commutation à semi-conducteur ($3_1$) ou que la première zone de connexion ($5_1$) du second élément de commutation à semi-conducteur ($3_2$) de chacune des n cellules de commutation (2, $2_1$, $2_2$, $2_3$, 2n) ou de chacun des n blocs parallèles de cellules de commutation (50).

**17.** Agencement de cellules de commutation comprenant n cellules de commutation ou n blocs parallèles de cellules de commutation selon la revendication 14 ou 16, **caractérisé en ce que** la première connexion ($4_1$) de l'alimentation à tension continue (4) est agencée au centre sur le premier côté du support de circuit (8), et **en ce que** la seconde connexion ($4_2$) de l'alimentation à tension continue (4) est agencée au centre sur le second côté du support de circuit (8), et **en ce que** les n cellules de commutation (2, $2_1$, $2_2$, $2_3$, 2n) ou les n blocs parallèles de cellules de commutation (50) sont agencé(e)s sur le support de circuit (8) d'une manière telle qu'ils/elles s'étendent radialement vers l'extérieur depuis le centre, et **en ce que** chacune des n cellules de commutation (2, $2_1$, $2_2$, $2_3$, 2n) ou chacun des n blocs parallèles de cellules de commutation (50) forme par rapport à sa cellule de commutation voisine (2, $2_1$, $2_2$, $2_3$, 2n) ou à son bloc parallèle de cellules de commutation voisin (50) un angle de $\gamma = 360°/n$.

**18.** Agencement de cellules de commutation comprenant n cellules de commutation ou n blocs parallèles de cellules de commutation selon la revendication 14, 16 ou 17, **caractérisé en ce que** la seconde connexion ($4_2$) de l'alimentation à tension continue (4) est agencée au centre du support de circuit (8), et **en ce que** la première connexion ($4_1$) est réalisée sous la forme d'une surface périphérique de forme annulaire, dans lequel la seconde connexion ($4_2$) de l'alimentation à tension continue (4) est agencée à l'intérieur de la première connexion ($4_1$), réalisée sous forme périphérique annulaire, séparément de celle-ci, et **en ce que** les n cellules de commutation (2, $2_1$, $2_2$, $2_3$, 2n) ou les n blocs parallèles de cellules de commutation (50) sont agencé(e)s sur le support de circuit (8) de manière telle qu'ils/elles s'étendent radialement vers l'extérieur depuis le centre, et **en ce que** chacune des n cellules de commutation (2, $2_1$, $2_2$, $2_3$, 2n) ou chacun des n blocs parallèles de cellules de commutation (50) forme par rapport à sa cellule de commutation voisine (2, $2_1$, $2_2$, $2_3$, 2n) ou à son bloc parallèle de cellules de commutation voisin (50) un angle de $\gamma = 360°/n$.

**19.** Redresseur comprenant deux agencements de cellules de commutation selon l'une des revendications 12 à 17, **caractérisé en ce que** les deux agencements de cellules de commutation (1) sont agencés et/ou sont réalisés de telle manière qu'un premier agencement de cellules de commutation (1) redresse une tension alternative, et qu'un second agencement de cellules de commutation (1) transforme une tension continue provenant du premier agencement de cellules de commutation (1) en une tension alternative, et **en ce que** le second agencement de cellules de commutation (1) redresse une tension alternative, et que le premier agencement de cellules de commutation (1) transforme une tension continue provenant du second agencement de cellules de commutation (1) en une tension alternative, de sorte qu'un flux d'énergie est rendu possible dans les deux directions.

Fig. 1A

Fig. 1B

Fig. 1C

Fig. 1D

Fig. 1E

Fig. 2A

Fig. 2B

Fig. 2C

Fig. 3A

Fig. 3B

Fig. 3C

Fig. 3D

Fig. 3E

Fig. 4A

Fig. 4B

Fig. 5

Fig. 6A

1

C_ZK

C_ZK

T1

Phase 1

$2_1$

C_ZK

C_ZK

T3

Phase 2

$2_2$

## Fig. 6B

$2_1$, 50    $2_2$, 50    $2_3$, 50

$V_{DC}$

$C_{ZK}$

$T_2$    $T_4$    $T_6$

$U_1$
$V_1$
$W_1$

3-Phasen Motor

$T_1$    $T_3$    $T_5$

## Fig. 7A

Fig. 7B

Fig. 7C

Fig. 7D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20130056755 A1

- DE 102013108148 A1